(19) **Europäisches Patentamt**
**European Patent Office**
**Office européen des brevets**

(11) **EP 4 765 204 A1**

(12) **EUROPEAN PATENT APPLICATION**
published in accordance with Art. 153(4) EPC

(43) Date of publication:
**24.06.2026 Bulletin 2026/26**

(21) Application number: **24853513.0**

(22) Date of filing: **23.07.2024**

(51) International Patent Classification (IPC):
***H01L 23/492*** (2006.01)   ***H01L 21/60*** (2006.01)

(52) Cooperative Patent Classification (CPC):
**H10W 70/20; H10W 72/071**

(86) International application number:
**PCT/CN2024/106885**

(87) International publication number:
**WO 2025/036101 (20.02.2025 Gazette 2025/08)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **15.08.2023  CN 202311026248**

(71) Applicant: **The University of Hong Kong
Hong Kong (HK)**

(72) Inventors:
• **HUANG, Mingxin
  Hong Kong 100000 (CN)**
• **WANG, Yi
  Hong Kong 100000 (CN)**

(74) Representative: **Patentanwälte
Ruff, Wilhelm, Beier, Dauster & Partner mbB
Kronenstraße 30
70174 Stuttgart (DE)**

(54) **WELDING ASSEMBLY FOR PACKAGING OF POWER SEMICONDUCTOR MODULE, AND METHOD FOR MANUFACTURING WELDING ASSEMBLY**

(57)    The present invention relates to a bonded assembly for power semiconductor module packaging. The bonded assembly comprises: a first component, having a non-copper metal layer as the outermost layer on a first side of the first component; a second component, having a first copper layer on a first side of the second component; and a connecting copper layer, whose two sides are respectively connected to the non-copper metal layer and the first copper layer to form a first interface and a second interface, thereby securing the first component and the second component together, wherein an average grain size of the connecting copper layer is 35 nm to 400 nm. The present invention further provides a bonded assembly for semiconductor chip packaging, involving multiple components; and a method for producing a bonded assembly for power semiconductor module packaging.

Fig.1

EP 4 765 204 A1

## Description

### Field of the Invention

The present invention relates to a bonded assembly for power semiconductor module packaging and a manufacturing method thereof. The bonded assembly is particularly suitable for packaging power semiconductor modules, especially those used in inverter modules of new energy vehicles.

### Background

New energy vehicles, which utilize clean energy sources and thus can achieve zero emissions, among other advantages, are expected to gradually replace fuel-powered vehicles and become the most predominant vehicle type in the market in the future. One of the core components of new energy vehicles is an electronic control system, within which an inverter module is responsible for high-frequency conversion of high-voltage, high-current direct current to alternating current. It acts as a power transfer station between vehicle's battery and a drive system. Therefore, the performance of the inverter module directly affects the performance of the powertrain of the new energy vehicles.

The performance and safety of the inverter module in a new energy vehicle are significantly influenced by its packaging. The core of packaging lies in soldering between key components such as a copper conductive film, a semiconductor chip (whose back surface is coated with one or more metal layers), a copper-clad substrate, and a heat sink to achieve electrical conductivity and thermal conductivity between them. Three main scenarios are involved: 1) the outermost metal layer (typically a gold layer, silver layer, etc.) on the back surface of the semiconductor chip and a copper layer of the copper-clad substrate are soldered together by a third low-melting-point metal solder; 2) the copper layer of the copper-clad substrate and a surface aluminum layer of an aluminum heat sink are connected by a third low-melting-point solder or a thermally conductive silicone pad; and 3) the outermost metal layer (typically an aluminum layer) on the front surface of the semiconductor chip and a surface copper layer of the copper conductive film are soldered together by a third low-melting-point metal solder. Tin-based solder with a low melting point is the most widely used solder in the industry. Tin-based solder has a melting point of 200 to 250°C and has excellent soldering properties (good wettability and spreadability, low surface tension, etc.) and service performance. A typical soldering method involves heating at a temperature slightly above the solder's melting point, e.g., 250°C, for 1 to 10 minutes in a vacuum or inert gas protective atmosphere.

However, soldered assemblies obtained using the tin-based solder have several drawbacks. On the one hand, tin is highly reactive at low temperatures, reacting with metals such as gold, silver, aluminum, titanium, and nickel to form intermetallic compounds at the soldering interface between the two. These intermetallic compounds rapidly grow at the interface under the operating temperatures of the inverter module, forming a layer rich in micron-sized intermetallic compounds (such as $Ag_3Sn$, $AuSn_4$, etc., depending on the metal reacting with tin). This layer reduces the electrical conductivity of the soldering interface and makes it highly susceptible to brittle cracking. This not only reduces the power of the inverter module, but also critically impacts its service life, introducing potential safety risks during vehicle operation. On the other hand, for instance, soldered assemblies obtained by soldering chips to the copper-clad substrates using tin-based solder contain large voids. These voids not only significantly reduce the electrical conductivity and the thermal conductivity of the soldered assembly, lowering the module's power and heat dissipation efficiency and preventing the module from achieving expected performance, but also become stress concentration zones under mechanical shock or thermal cycling, promoting microcracks formation, reducing shear strength and causing premature fracture, thereby shortening the module's service life. At least due to these problems in current soldered assemblies, the power enhancement of existing inverter modules remains constrained, and their reliable operation under high-temperature conditions remains challenging to achieve.

Therefore, there is an urgent need for a bonded assembly capable of maintaining stable long-term service under high temperatures. It should at least mitigate or eliminate the aforementioned technical problems arising from soldering dissimilar metals, namely the decline in performance (such as shear strength and electrical conductivity) due to voids and brittle intermetallic compounds, thereby enhancing the long-term service performance of devices including such a bonded assembly.

### Summary of the Invention

The present invention is made in light of the aforementioned existing problems.

One object of the present invention is to provide a bonded assembly for power semiconductor module packaging, the bonded assembly comprising:

a first component, having a non-copper metal layer as the outermost layer on a first side of the first component;
a second component, having a first copper layer on a first side of the second component;

a connecting copper layer, whose two sides are respectively connected to the non-copper metal layer and the first copper layer to form a first interface and a second interface, thereby securing the first component and the second component together,

wherein an average grain size of the connecting copper layer is 35 nm to 400 nm.

The average grain size of the connecting copper layer is preferably 35 nm to 380 nm, more preferably 45 nm to 380 nm, still more preferably 60 nm to 220 nm, and yet more preferably 45 nm to 140 nm. Preferably, the connecting copper layer has an average thickness of 70 nm to 5 μm, more preferably 90 nm to 5 μm, still more preferably 500 nm to 5 μm, and the average thickness of the connecting copper layer is at least one time its average grain size.

Preferably, within a region defined by a width extending 1 μm outward from the first interface and from the second interface respectively in a direction away from the connecting copper layer and a length of any 10 μm along a length direction of the first/second interface, an average porosity of the bonded assembly is $\leq$ 3%, and a pore size of the bonded assembly is $\leq$ 200 nm. More preferably, the average porosity of the bonded assembly is $\leq$ 1%.

Preferably, for the bonded assembly, 1) the first component is a semiconductor chip and the second component is a copper-clad substrate; or 2) the first component is a semiconductor chip and the second component is a copper conductive film or a copper foil; or 3) the first component is a heat sink and the second component is a copper-clad substrate.

Preferably, the non-copper metal layer is a gold layer, and the average grain size of the connecting copper layer is 35 nm to 140 nm.

Preferably, the non-copper metal layer is a silver layer, and the average grain size of the connecting copper layer is 100 nm to 400 nm. This is because, at the same temperature, the diffusion coefficient of silver in copper and the diffusion coefficient of copper in silver are closer, thus the requirement for the average grain size needed to mitigate the Kirkendall effect is not as stringent as for the gold layer.

Preferably, the first copper layer is formed by an initial copper layer of the copper-clad substrate or the copper conductive film, and has an average grain size $\geq$ 500 nm.

Also preferably, the bonded assembly further comprises:

a second copper layer provided on a second side of the second component;
a third component, having a non-copper metal layer as the outermost layer on a first side of the third component;
an additional connecting copper layer, whose two sides are respectively connected to the non-copper metal layer of the third component and the second copper layer, thereby securing the second component and the third component together;
wherein an average grain size of the additional connecting copper layer is 35 nm to 400 nm.

It will be understood that the bonded assembly may further similarly comprise more components and corresponding connecting copper layers, having an average grain size of 35 nm to 400 nm, for bonding them together.

Preferably, a shear strength of the aforementioned bonded assembly is 30 to 40 MPa, more preferably 35 to 40 MPa, and a resistivity of the connecting copper layer is $\leq$ 5 μΩ·cm.

Preferably, the chip involved in the present invention comprises a functional chip having silicon, silicon carbide, or gallium nitride as its main material, having one or more metal layers on its front surface and back surface, and having a non-copper metal layer as the outermost metal layer. Preferably, the outermost metal layer may be a gold layer, an aluminum layer, a silver layer, a nickel layer, or a titanium layer. Preferably, the chip may be an Insulated Gate Bipolar Transistor (IGBT) chip, a Metal-Oxide-Semiconductor Field-Effect Transistor (MOSFET) chip, a Bipolar Junction Transistor (BJT) chip, or a Fast Recovery Diode (FRD) chip.

Preferably, the copper-clad substrate involved in the present invention may be any substrate with a copper surface layer, including but not limited to a Direct Bond Copper ceramic substrate (DBC), an Active Metal Brazed ceramic substrate (AMB), or a copper-clad metal heat dissipation structure.

Preferably, the heat sink involved in the present invention is a heat dissipation structure with an aluminum surface layer.

Another object of the present invention is to provide a bonded assembly for power semiconductor module packaging, comprising:

a semiconductor chip, having non-copper metal layers as the outermost layers on a first side and a second side of the semiconductor chip;
a copper-clad substrate, having a first copper layer and a second copper layer on a first side and a second side respectively of the copper-clad substrate;
a heat sink, having an aluminum layer on a first side of the heat sink;
a copper conductive film, having a third copper layer on a first side of the copper conductive film;

a first connecting copper layer, whose two sides are respectively connected to the non-copper metal layer on the first side of the semiconductor chip and the third copper layer, thereby securing the semiconductor chip and the copper conductive film together;

a second connecting copper layer, whose two sides are respectively connected to the non-copper metal layer on the second side of the semiconductor chip and the first copper layer, thereby securing the semiconductor chip and the copper-clad substrate together; and

a third connecting copper layer, whose two sides are respectively connected to the second copper layer and the aluminum layer, thereby securing the copper-clad substrate and the heat sink together;

wherein average grain sizes of the first, second, and third connecting copper layers are 35 nm to 400 nm.

Preferably, the average grain sizes of the first and second connecting copper layers are 35 nm to 380 nm, more preferably 45 nm to 380 nm, even more preferably 60 nm to 220 nm, and still more preferably 45 nm to 140 nm; the average grain size of the third connecting copper layer is preferably 35 nm to 380 nm, and more preferably 62 nm to 250 nm. Preferably, the non-copper metal layer of the semiconductor chip is a gold layer, an aluminum layer, a silver layer, a nickel layer, or a titanium layer. Preferably, the bonded assembly has an average porosity of $\leq 3\%$, more preferably $\leq 1\%$, and a pore size of $\leq 200$ nm.

A further object of the present invention is to provide a method for producing a bonded assembly for power semiconductor module packaging, comprising the following steps:

a) providing a first component and a second component to be bonded together, and performing cleaning and drying, wherein a first side of the second component has an initial copper layer, and the outermost layer on a first side of the first component is a non-copper metal layer, such as a gold layer, an aluminum layer, a silver layer, a nickel layer, or a titanium layer;

b) introducing a pre-plated copper layer on the cleaned surface of the initial copper layer of the second component or on the cleaned outermost layer on the first side of the first component, and cleaning to remove an oxide layer on the surface of the pre-plated copper layer, wherein an average grain size of the pre-plated copper layer is 20 nm to 360 nm;

c) correspondingly bringing the pre-plated copper layer on the second component or the first component into surface contact with the non-copper metal layer of the first component or the initial copper layer of the second component, to form a stacked structure;

d) bonding the first component and the second component together using diffusion bonding, thereby obtaining the bonded assembly of the present invention.

Preferably, the average grain size of the pre-plated copper layer is 25 nm to 360 nm, more preferably 30 nm to 300 nm, and an average thickness of the pre-plated copper layer is greater than or equal to twice the average grain size. More preferably, the average thickness of the pre-plated copper layer is 100 nm to 5 $\mu$m, even more preferably 500 nm to 5 $\mu$m, and is at least three times the average grain size.

Preferably, the first component is a semiconductor chip, and its non-copper metal layer is a gold layer, an aluminum layer, a silver layer, a nickel layer, or a titanium layer. Preferably, the first component is a heat sink with an aluminum layer as its surface, and an average grain size of the pre-plated copper layer is 30 nm to 200 nm, and an average thickness of the pre-plated copper layer is 100 nm to 3 $\mu$m and at least three times the average grain size.

Preferably, in step d), the diffusion bonding is performed as follows: in a helium protective atmosphere at a temperature of 250 to 350°C, applying pressure from both the top and the bottom of the stacked structure, with a pressure of 15 to 40 MPa, and a holding time of 10 to 30 minutes. More preferably, the holding temperature is 250 to 300°C, or the pressure is 20 to 30 MPa, or the holding time is 10 to 20 minutes.

Preferably, the pre-plated copper layer is formed by electroplating, vapor deposition, sputtering, ion plating, or similar methods to provide a pre-plated copper layer with relatively uniform thickness and grain size.

Preferably, in step b), the pre-plated copper layer is formed by electrochemical deposition using an electrolyte solution containing 200 to 250 g/L of anhydrous copper sulfate, 10 to 50 ml/L of sulfuric acid, and 0.01 to 0.05 g/L of thiourea, with a solution temperature of 30°C. More preferably, the electrochemical deposition is performed at a current density of 0.05 to 0.15 A/cm$^2$ for a duration of 60 to 300 seconds. Further preferably, the electrolyte solution contains 200 to 250 g/L of anhydrous copper sulfate, 10 to 50 ml/L of sulfuric acid, and 0.005 to 0.01 g/L of thiourea, with a solution temperature of 30°C. More preferably, the electrochemical deposition is performed at a current density of 0.01 to 0.04 A/cm$^2$ for a duration of 250 to 350 seconds.

The method of the present invention achieves a bonded assembly with improved performance through simple operations. Specifically, by providing a dense pre-plated copper layer for bonding two components and controlling its grain size, the present invention obtains a connecting copper layer with a desired grain size, whereby the finally obtained bonded assembly has a low porosity and low resistivity. In addition, due to the low reactivity and small lattice parameter of copper, its reaction with dissimilar metals is extremely slow, resulting in minimal intermetallic compounds formed in the bonded assembly. Therefore, the bonded assembly obtained by the method of the present invention exhibits low porosity and low resistivity, has substantially no intermetallic compounds, and possesses excellent electrical conductivity, thermal conductivity, and high shear strength.

Furthermore, during service, a high grain boundary volume fraction of the connecting copper layer in the bonded assembly provides rapid diffusion channels for dissimilar metals, allowing diffusion rates of dissimilar metal atoms to be between 1/6 and 6 times, more preferably between 0.5 and 2 times, the diffusion rate of copper atoms. This ensures that the atomic flux into and out of the connecting copper layer is essentially balanced, fundamentally mitigating or preventing the formation of Kirkendall voids. At the same time, the bonded assembly has minimal intermetallic compounds. The combination of these two factors ensures that even during prolonged operation in high-temperature environments, the bonded assembly neither develops significant Kirkendall voids and its growth nor experiences intermetallic compound coarsening, thereby avoiding substantial degradation of mechanical properties and improving the long-term service stability of the bonded assembly.

Compared with prior arts, the bonded assembly of the present invention for connecting dissimilar metals in power semiconductor module packaging has excellent properties and stable performance during service. It solves the problems of low mechanical strength, high resistivity, and poor thermal dissipation caused by the formation of Kirkendall voids and intermetallic compounds in the soldered assembly of dissimilar metals during service.

In addition, it will be understood by those skilled in the art that any range or any value within the aforementioned ranges is applicable to the present invention. For example, an average grain size of the connecting copper layer in the range of 35 nm to 400 nm means that any range or specific numerical value within this range may be selected. For instance, an average grain size is of any range such as 35 nm to 320 nm, 40 nm to 300 nm, 50 nm to 300 nm, 50 nm to 280 nm, 50 nm to 250 nm, 50 nm to 200 nm, 42 nm to 200 nm, 45 nm to 150 nm, 40 nm to 150 nm, 35 nm to 100 nm, 50 nm to 150 nm, or 50 nm to 100 nm, etc.; or an average grain size is any specific value such as 55 nm, 68 nm, 75 nm, 85 nm, 90 nm, 110 nm, 140 nm, 170 nm, 220 nm, 260 nm, 275 nm, 300 nm, 320 nm, 340 nm, 368 nm, etc.

## Brief Description of the Drawings

Fig. 1 shows an exemplary scenario including a bonded assembly according to the present invention;

Fig. 2 shows a Structured Illumination Microscopy (SIM) image of a cross-section of a copper-clad ceramic substrate after deposition of a pre-plated copper layer according to a first embodiment of the present invention;

Fig. 3 shows an Atomic Force Microscopy (AFM) image of a surface morphology of the pre-plated copper layer on the copper-clad ceramic substrate after deposition of the pre-plated copper layer according to the first embodiment of the present invention;

Fig. 4 shows a Scanning Electron Microscopy (SEM) image of a cross-section of a bonded assembly according to the first embodiment of the present invention;

Fig. 5 shows a locally enlarged SEM image of Fig. 4;

Fig. 6 shows a Transmission Electron Microscopy (TEM) image of the cross-section of the bonded assembly according to the first embodiment of the present invention;

Fig. 7 shows a SEM image of a shear fracture surface of the bonded assembly according to the first embodiment of the present invention;

Fig. 8 shows a SEM image of the cross-section of the bonded assembly according to the first embodiment of the present invention after being held at 250°C for 165 hours;

Fig. 9 shows a locally enlarged TEM image of the cross-section of the bonded assembly according to the first embodiment of the present invention after being held at 250°C for 165 hours;

Fig. 10 shows a SEM image of the shear fracture surface of the bonded assembly according to the first embodiment of the present invention after being held at 250°C for 165 hours;

Fig. 11 shows a SEM image of a cross-section of a bonded assembly according to a second embodiment of the present invention;

Fig. 12 shows a TEM image of the cross-section of the bonded assembly according to the second embodiment of the present invention;

Fig. 13 shows a SEM image of the cross-section of the bonded assembly according to the second embodiment of the present invention after being held at 250°C for 165 hours;

Fig. 14 shows a locally enlarged TEM image of the cross-section of the bonded assembly according to the second embodiment of the present invention after being held at 250°C for 165 hours;

Fig. 15 shows a SEM image of a cross-section of a bonded assembly according to a third embodiment of the present invention;

Fig. 16 shows a TEM image of the cross-section of the bonded assembly according to the third embodiment of the present invention;

Fig. 17 shows a SEM image of the cross-section of the bonded assembly according to the third embodiment of the present invention after being held at 250°C for 165 hours.

Fig. 18 shows a locally enlarged TEM image of the cross-section of the bonded assembly according to the third embodiment of the present invention after being held at 250°C for 165 hours;

Fig. 19 shows a soldered assembly of a silicon-based IGBT chip and a copper-clad ceramic substrate soldered with tin-based solder paste SAC305 in a first comparative example;

Fig. 20 shows a SEM image of a cross-section of the soldered assembly of the first comparative example after being held at 200°C for 72 hours;

Fig. 21 shows a SEM image of a shear fracture surface of the soldered assembly of the first comparative example after being held at 200°C for 72 hours;

Fig. 22 shows a SIM image of a cross-section of a copper-clad ceramic substrate of a second comparative example after annealing a pre-plated copper layer;

Fig. 23 shows an AFM image of a surface morphology of an annealed pre-plated copper layer on the copper-clad ceramic substrate of the second comparative example;

Fig. 24 shows a SEM image of a cross-section of a bonded assembly of the second comparative example; and

Fig. 25 shows a SEM image of the cross-section of the bonded assembly of the second comparative example after being held at 250°C for 165 hours.

## Detailed Description

The following describes the present invention in conjunction with specific embodiments. The detailed description and accompanying drawings illustrate several implementations, which are intended to explain the disclosure. It should be understood that although one or more exemplary embodiments are shown below, the present disclosure should by no means be limited to the exemplary embodiments, drawings, and techniques shown below, but can be modified within the full scope of the appended claims and their equivalents. It should be understood that any numbering (e.g., first, second, etc.) of the disclosed features and directional terms (e.g., front, back, up, down, etc.) used in connection with the disclosed features are relative terms indicating exemplary relationships between related features or used to differentiate related features. The word "example" as used herein is intended to mean serving as an example, instance, or illustration. Unless explicitly stated otherwise, all ranges include endpoints. Those skilled in the art will understand that data and various parameters recorded in the embodiments are only exemplary and do not constitute a limitation on the present invention.

The inventors of the present invention have discovered that tin-based soldered assemblies have the defect of low strength, mainly due to the following reasons: on the one hand, tin is highly reactive and tends to react with various components of the surfaces that need to be soldered during a packaging process, forming brittle intermetallic compounds, such as $AuSn_4$ when reacting with Au, $Ag_3Sn$ with Ag, $Cu_3Sn$ and $Cu_6Sn_5$ with Cu, and $Ni_3Sn$ with Ni, etc. Since the energy required for the formation and growth of the aforementioned intermetallic compounds is generally low, they can rapidly form and grow even in low-temperature environments, resulting in a weak interface layer with low strength and in turn high susceptibility to fracture under stress. This makes the device susceptible to early failure during service. On the other hand, tin atoms and atoms of dissimilar metals interdiffuse across the soldering interface. When the diffusion rates of the two species of atoms are significantly different, a large number of Kirkendall voids form near the soldering interface on the side where atoms diffuse away rapidly because the vacancies left by the rapidly diffusing atoms cannot be timely filled by the slow-diffusing atoms. These voids grow over time during service, forming stress concentration zones. Under stress, the soldered assembly becomes highly susceptible to cracking along these voids, creating an additional mechanically weak layer that gradually degrades the strength of the soldered assembly during service. Besides, the presence of a large number of voids reduces the electrical conductivity and the thermal conductivity of the soldered assembly, which is unfavorable for the improvement in the operational power of the device.

Similarly, the Kirkendall effect also exists in the interdiffusion between a coarse-grained copper layer and a non-copper metal layer. In the present invention, copper with a grain size greater than 400 nm is defined as coarse-grained copper; conversely, grains not larger than 400 nm are defined as fine grains. For example, at 250°C, the diffusion rate of copper atoms in a gold layer $D_{Cu/Au}$ is $2.2 \times 10^{-18}$ m2/s, while the diffusion rate of gold atoms in a coarse-grained copper layer $D_{Au/Cu}$ is $2.4 \times 10^{-21}$ m2/s. The former is approximately 1000 times the latter. Therefore, for a bonded assembly formed by a coarse-grained copper layer and a non-copper metal layer, during both the bonding process forming it and subsequent high-temperature operation, because dissimilar metal atoms (e.g., gold atoms) diffuse slowly, they cannot fill the vacancies left by the rapidly diffusing copper atoms within the coarse-grained copper layer. This results in a large number of Kirkendall voids within the coarse-grained copper layer near the bonding interface between the non-copper metal layer and the coarse-grained copper layer. These voids not only become weak points in the device containing such a bonded assembly but also reduce the electrical conductivity and the thermal conductivity of the bonded assembly, adversely affecting the device's performance in use.

To avoid or at least mitigate the impact of Kirkendall voids on the performance of the bonded assembly, the inventors of the present invention proposed increasing the diffusion rate of dissimilar metal atoms within an adjacent copper layer to a level comparable to that of copper atoms, so as to achieve a near-balance in the diffusion rates of different atoms entering and leaving the copper layer, thereby avoiding or reducing void formation. The inventors realized that the diffusion rate of the dissimilar metal can be adjusted by controlling the grain boundary volume fraction. This is because atoms are loosely arranged at grain boundaries. As a result, compared to the energy barrier that atom migration needs to overcome within the orderly arranged grains interiors, energy barrier that atoms need to overcome to break the arrangement at grain boundaries is lower. Consequently, diffusion rates are higher at grain boundaries, which can thus serve as fast diffusion pathways for atoms. Therefore, the present invention proposes utilizing this characteristic of fast atomic diffusion at grain boundaries to solve the aforementioned problems.

Specifically, for a copper layer with a smaller grain size, a diffusion length of a dissimilar metal is greater than the grain size, thus satisfying Harrison type A diffusion model, where grain boundary diffusion and lattice diffusion occur simultaneously. In this case, an effective diffusion rate $D_{eff}$ considering the two diffusion mechanisms can be calculated using the following formula (1):

$$D_{eff} = f_{gb}D_{gb} + D_l \qquad (1)$$

where,

$f_{gb}$ is the grain boundary volume fraction;
$D_{gb}$ is the grain boundary diffusion coefficient;
$D_1$ is the lattice diffusion coefficient;

Since factors such as $D_{gb}$ and $D_1$ can be considered constant for the same system (e.g., Cu-Au system) at the same temperature, the diffusion rate of the dissimilar metal (specifically depending on the surface metal layer of the first component used for bonding) within the adjacent copper layer (such as the connecting copper layer in the aforementioned bonded assembly) can be controlled by adjusting the grain boundary volume fraction $f_{gb}$, so that it at least approximately matches the diffusion rate of copper atoms. In this application, "approximately matched" diffusion rates mean that the diffusion rate of the dissimilar metal atoms falls between 1/6 and 6 times that of copper atoms, more preferably between 0.5 and 2 times.

$f_{gb}$ is influenced by the grain size and can be calculated using the following formula (2):

$$f_{gb} = \frac{3\Delta}{d} \qquad (2)$$

where, $\Delta$ is the grain boundary thickness, taken as 0.5 nm, and $d$ is the grain size.

According to this formula, control over the grain boundary volume fraction can be achieved by controlling the grain size. Since the operating temperature of the future applications of third-generation SiC semiconductor chip high-power devices is 200 to 300°C, and higher operating temperatures make them more susceptible to the Kirkendall effect, the temperature adjustment range addressed in the present invention is in the range of 200 to 300°C. Within this temperature range, by controlling the grain size of the connecting copper layer in contact with the dissimilar metal to be not greater than 400 nm (i.e., the connecting copper layer is a fine-grained copper layer), a grain boundary volume fraction of at least 0.375% is obtained. And this grain boundary volume fraction increases as the grain size decreases. For example, when the grain size is 35 nm, the grain boundary volume fraction is as high as approximately 4.3%, such that the diffusion coefficient of the dissimilar metal in the copper layer and the diffusion coefficient of copper in the dissimilar metal satisfy $1/6D_{Cu/X} \leq D_{X/Cu\text{-eff}} \leq 6D_{Cu/X}$, where $D_{Cu/X}$ is the diffusion coefficient of Cu atoms in metal X, and $D_{X/Cu\text{-eff}}$ is the effective diffusion coefficient of metal X atoms in the connecting copper layer. By narrowing the difference between the diffusion coefficients of dissimilar metal atoms and copper atoms, the formation and growth of Kirkendall voids during service are reduced or even suppressed.

If the average grain size of the aforementioned copper layer is >400 nm, the grain boundary volume fraction of the copper layer is <0.375%. This results in insufficient grain boundaries to act as fast pathways to promote rapid diffusion of the dissimilar metal, i.e., the difference in diffusion coefficients between dissimilar metal atoms and copper atoms remains significant. Consequently, the problems caused by Kirkendall voids cannot be considerably alleviated. In addition, while smaller grains (i.e., larger grain boundary volume fractions) can further increase the diffusion rate of dissimilar metal atoms in the copper layer, when the grains are excessively small, the diffusion rate of dissimilar metal atoms may become excessively higher than that of copper atoms, potentially still inducing the Kirkendall effect. Therefore, the present invention requires that the average grain size of the connecting copper layer be not less than 35 nm, i.e., the average grain size of the connecting copper layer between the two bonded components is 35 nm to 400 nm.

Taking a Cu-X system where the dissimilar metal X is Au, Ag, Al, Ti or Ni as an example, $D_{X/Cu-eff}$ at the preferred grain size is calculated according to the above equations (1) and (2), where $D_{gb}$ and $D_1$ take the values of $D_{X/Cu-gb}$ and $D_{X/Cu-1}$, respectively. Table 1 lists the preferred grain sizes of the connecting copper layers in these Cu-X systems and, correspondingly, the calculated diffusion coefficients of dissimilar metal X atoms in the connecting copper layers, which satisfy $0.5D_{Cu/X} \leq D_{X/Cu-eff} \leq 2D_{Cu/X}$. $D_{Cu/X}$ is the diffusion coefficient of Cu atoms in metal X; $D_{X/Cu}$ is the diffusion coefficient of metal X atoms in the connecting copper layer; $D_{X/Cu-gb}$ is the grain boundary diffusion coefficient of metal X atoms in the connecting copper layer; $D_{X/Cu-1}$ is the lattice diffusion coefficient of metal X atoms in the connecting copper layer; $D_{X/Cu-eff}$ is the effective diffusion coefficient of metal X atoms in the connecting copper layer; $^{1*}D_{X/Cu-eff}$ is the effective diffusion coefficient of metal X atoms in a connecting copper layer with an average grain size of 35 nm; $^{2*}D_{X/Cu-eff}$ is the effective diffusion coefficient of metal X atoms in a connecting copper layer with an average grain size of 400 nm. $^{1*}D_{X/Cu-eff}$ and $^{2*}D_{X/Cu-eff}$ satisfy $1/6D_{Cu/X} \leq D_{X/Cu-eff} \leq 6D_{Cu/X}$.

Table 1: Preferred Grain Sizes of the Connecting Copper Layers in Cu-X Systems and Diffusion Coefficients at 250°C

| Dissimilar Metal X | Au | Ag | Al | Ti | Ni |
|---|---|---|---|---|---|
| $D_{Cu/X}$ /m²s⁻¹ | $2.2 \times 10^{-18}$ | $8.3 \times 10^{-17}$ | $1.0 \times 10^{-17}$ | $1.6 \times 10^{-21}$ | $4.0 \times 10^{-21}$ |
| $D_{X/Cu}$ /m²s⁻¹ | $2.4 \times 10^{-21}$ | $3.5 \times 10^{-17}$ | $4.2 \times 10^{-19}$ | $2.1 \times 10^{-23}$ | $9.8 \times 10^{-23}$ |
| $D_{X/Cu-gb}$ /m²s⁻¹ | $1.0 \times 10^{-16}$ | $1.1 \times 10^{-14}$ | $8.3 \times 10^{-16}$ | $1.0 \times 10^{-19}$ | $2.0 \times 10^{-19}$ |
| $D_{X/Cu-1}$/m²s⁻¹ | $5.0 \times 10^{-24}$ | $3.0 \times 10^{-18}$ | $4.4 \times 10^{-23}$ | $2.1 \times 10^{-26}$ | $1.9 \times 10^{-26}$ |
| Average Grain Size of the Connecting Copper Layer/nm | 35~140 | 100~400 | 62~250 | 47~187 | 38~150 |
| $D_{X/Cu-eff}$/m²s⁻¹ | $1.1~4.3 \times 10^{-18}$ | $4.4~17 \times 10^{-17}$ | $0.5~2.0 \times 10^{-17}$ | $0.8~3.2 \times 10^{-21}$ | $2.0~7.9 \times 10^{-21}$ |
| $^{1*}D_{X/Cu-eff}$/m²s⁻¹ | $4.3 \times 10^{-18}$ | $4.7 \times 10^{-16}$ | $3.6 \times 10^{-17}$ | $4.3 \times 10^{-21}$ | $8.6 \times 10^{-21}$ |
| $^{2*}D_{X/Cu-eff}$/m²s⁻¹ | $3.8 \times 10^{-19}$ | $4.14 \times 10^{-17}$ | $3.1 \times 10^{-18}$ | $3.8 \times 10^{-22}$ | $7.5 \times 10^{-22}$ |

Taking Cu/Au system as an example, it is known that at 250°C, the diffusion rate $D_{Cu/Au}$ of Cu in Au is $2.2 \times 10^{-18}$ m²s⁻¹, while the diffusion rate $D_{Au/Cu}$ of Au in Cu is $2.4 \times 10^{-21}$ m²s⁻¹, which is significantly lower than the former. If the average grain size of the connecting copper layer is controlled to be 35 nm, the grain boundary volume fraction is $f_{gb} = 3 \times 0.5 \times 10^{-9} / (35 \times 10^{-9}) = 0.0429$. Substituting this into formula (1), the effective diffusion rate $D_{Au/Cu-eff}$ of Au in Cu = $(0.0429 \times 1.0 \times 10^{-16}) + 5.0 \times 10^{-24} = 4.3 \times 10^{-18}$ m²s⁻¹, which is approximately twice $D_{Cu/Au}$. Correspondingly, when the average grain size of the connecting copper layer is 140 nm, according to formula (1), $D_{Au/Cu-eff}$ is $1.1 \times 10^{-18}$ m²s⁻¹, which is 0.5 times $D_{Cu/Au}$. Furthermore, when the average grain size of the connecting copper layer is 400 nm, according to formula (1), $D_{Au/Cu-eff}$ is $3.8 \times 10^{-19}$ m²s⁻¹, which is approximately 0.173 times $D_{Cu/Au}$. Therefore, when the average grain size of the connecting copper layer at 250°C is within the range of 35 nm to 400 nm, the effective diffusion rate $D_{Au/Cu-eff}$ of Au in Cu satisfies $1/6D_{Cu/Au} \leq D_{Au/Cu-eff} \leq 6D_{Cu/Au}$, meaning the diffusion rates of Cu and Au are approximately matched. This significantly mitigates the Kirkendall effect. Moreover, when the average grain size of the connecting copper layer is between 35 nm and 140 nm, the effective diffusion rate $D_{Au/Cu-eff}$ of Au in Cu satisfies $0.5D_{Cu/Au} \leq D_{Au/Cu-eff} \leq 2D_{Cu/Au}$. The further reduction in the difference between the diffusion rates of Cu and Au can further mitigate the Kirkendall effect, resulting in a bonded assembly with better performance. Similarly, for other dissimilar metals X, controlling the average grain size of the connecting copper layer to be between 35 nm and 400 nm can also effectively reduce the difference between the diffusion rates of the dissimilar metal X and Cu. Furthermore, within the preferred grain size ranges corresponding to various metals, the difference in diffusion rates between the dissimilar metal X and Cu can be further reduced. In addition, while illustrative data is provided only for 250°C, the preferred average grain size of the connecting copper layer is applicable to the anticipated temperature range of 200 to 300°C.

Furthermore, to achieve a desired grain boundary volume fraction, i.e., a desired grain size, of the connecting copper layer (i.e., the fine-grained copper layer) in the bonded assembly, the manufacturing method of the present invention proposes controlling the grain size of a pre-plated copper layer used for bonding, such that the grain size of the connecting copper layer is between 35 nm and 400 nm. In this case, whether during the formation of the bonded assembly or during its subsequent service life, the fine grain size of both the pre-plated copper layer and the connecting copper layer increases the diffusion rate of the dissimilar metal to be bonded within these copper layers, to a level close to that of copper in the dissimilar metal, thereby avoiding or at least reducing the formation and growth of Kirkendall voids during both the bonding process and service. As a result, the performance degradation of the bonded assembly due to the Kirkendall effect is generally prevented or at least mitigated, improving the performance of the bonded assembly. Besides, the inherent stability of copper prevents the formation of brittle intermetallic compounds during the bonding process, thereby avoiding the impact of intermetallic compounds on the performance of the obtained bonded assembly.

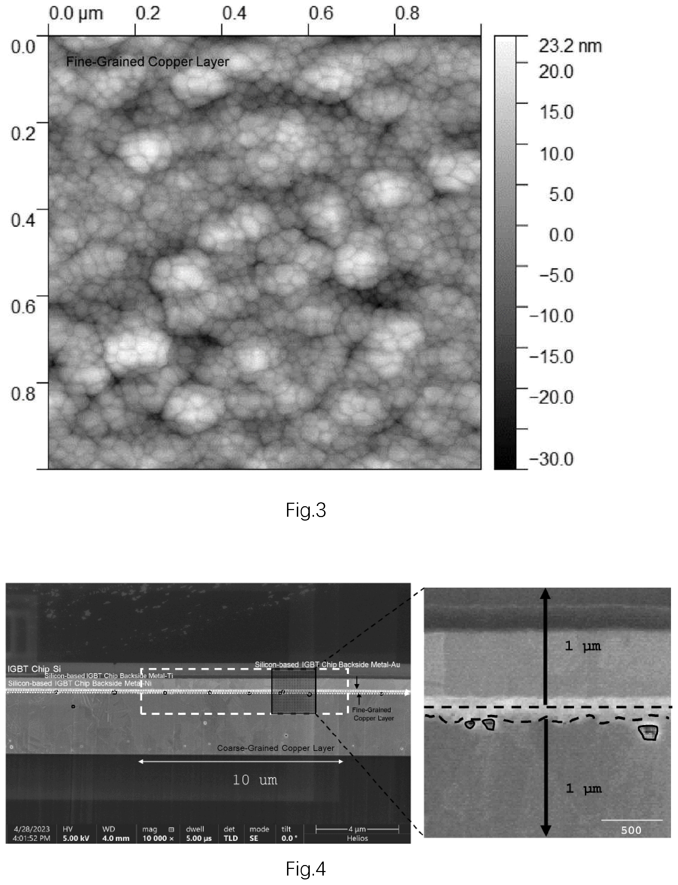

In the present invention, porosity is defined as the ratio of a total pore area to a sampling area. The method for measuring the porosity of a bonded assembly is as follows: On a cross-section of the obtained bonded assembly, sampling is conducted within a region defined by a width extending 1 $\mu$m outward from the aforementioned first interface and from the aforementioned second interface, respectively, in a direction away from the connecting copper layer (i.e., including the connecting copper layer), and a length of any 10 $\mu$m along a length direction of the first/second interface. The total area of all visible pores within the sampling region at each location is measured using image processing software ImageJ. Subsequently, the porosity at each sampling location is calculated individually based on the measurement results, and then averaged. As schematically illustrated in Fig. 4, the width of the field of view extends 1 $\mu$m outward from the interface between a gold layer and a connecting copper layer and from the interface between the connecting copper layer and a coarse-grained copper layer, respectively, in a direction away from the connecting copper layer, and the length thereof is any 10 $\mu$m along a length direction of the interface.

In the present invention, the resistivity of the connecting copper layer is tested as follows: By simulating the bonding scenario, a pre-plated copper layer with the same thickness as used in actual bonding is deposited onto the surface of a first copper layer on a silicon wafer with the first copper layer of 1 $\mu$m. A non-copper metal layer with the same thickness as the outermost non-copper metal layer on the component to be bonded is then directly sputtered onto the pre-plated copper layer. Heating and pressing are applied to simulate the bonded assembly obtained after bonding. Subsequently, four-point probe thin-film resistivity measurement is performed on the surface of the bonded assembly, with the measurement depth covering the non-copper metal layer, the connecting copper layer, and a small portion of the first copper layer. This resistivity can reflect the impact of Kirkendall voids on the bonded assembly.

In the present invention, the shear fracture testing method is as follows: The bottom of a second component of a bonded assembly is fixed to a test platform using resin. A movable mechanical component is pressed against a side of a first component of the bonded assembly to apply a shear force parallel to the sample at a moving speed of 20 $\mu$m/min. Five samples of each product are tested, and the average value is taken.

The excellent performance of the bonded assembly of the present invention will be described below with specific examples. It will be understood that the following embodiments are merely specific examples of the bonded assembly of the present invention and are in no way intended to limit the invention in any manner.

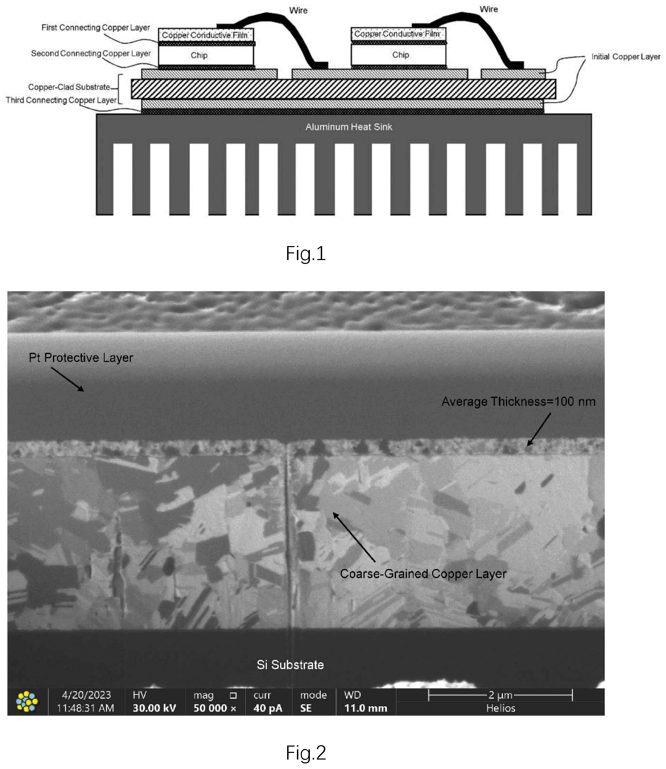

Fig. 1 schematically illustrates a combined bonded assembly according to the present invention, schematically showing various application scenarios to which the bonded assembly of the invention can be applied, such as a bonded assembly consisting of a chip and a copper conductive film. It will be understood that the illustrated scenarios may exist individually or in combination and will be described schematically in respective embodiments.

First Embodiment

A method for producing a bonded assembly according to a first embodiment of the present invention is as follows:

Step 1.1: Providing a copper-clad ceramic substrate and a silicon-based IGBT chip to be bonded together, wherein the surface of the copper-clad ceramic substrate has an initial copper layer with a thickness of approximately 2.4 $\mu$m, formed by coarse grains with an average grain size not less than 500 nm (see Fig. 2). Grain size measurement is based on the maximum size of each grain shown in the figure. The backside metal layers of the silicon-based IGBT chip are, from the inside out, a titanium layer, a nickel layer, and a gold layer;

Step 1.2: Sequentially cleaning the surface of the initial copper layer on the copper-clad ceramic substrate with acetone, anhydrous ethanol, and dilute hydrochloric acid (HCl:$H_2$O = 1:1, by volume fraction) using an ultrasonic cleaning method, followed by rinsing with deionized water and drying in order to remove surface impurities and oxide layer;

Step 1.3: Sequentially cleaning the surface of the gold layer of the silicon-based IGBT chip with acetone, anhydrous ethanol, and isopropanol (IPA) using an ultrasonic cleaning method, followed by rinsing with deionized water and drying;

Step 1.4: Depositing a pre-plated copper layer within a 10 mm $\times$ 10 mm area on the surface of the initial copper layer through electrochemical deposition, wherein the parameters for the electrochemical deposition are as follows: direct current plating with a current density of 0.05 to 0.15 A/cm$^2$, an electrolyte solution contains 200 to 250 g/L anhydrous copper sulfate, 10 to 50 ml/L sulfuric acid, and 0.01 to 0.05 g/L thiourea. Deposition time is 60 seconds, and solution temperature is 30°C. Fig. 2 shows a SIM image of a cross-section of the copper-clad ceramic substrate after depositing the pre-plated copper layer, wherein the average thickness of the deposited pre-plated copper layer is approximately 100 nm. In actual production applications, the thickness of the connecting copper layer can be appropriately adjusted as needed. To protect the deposited pre-plated copper layer during cross-section preparation, an additional Pt protective layer is deposited on the pre-plated copper layer before sectioning. Fig. 3 shows an AFM image of a surface morphology of the pre-plated copper layer on the copper-clad ceramic substrate after deposition of the pre-plated copper layer, wherein the average grain size of the pre-plated copper layer is approximately 30 nm, significantly smaller than the grain size of the underlying initial copper layer. Preferably, similarly, this pre-plated copper layer may be deposited on the gold layer of the silicon-based IGBT chip. Preferably, to avoid the influence of certain grain orientations in a single layer of grains on the diffusion rate of atoms, the thickness of the pre-plated copper layer is at least 2 times, more preferably 3 times, its average grain size;

Step 1.5: Cleaning the surface of the pre-plated copper layer on the copper-clad ceramic substrate with dilute hydrochloric acid ($HCl:H_2O$ = 1:1, by volume fraction) to remove surface oxide layer;

Step 1.6: Bring the gold layer of the silicon-based IGBT chip into surface contact with the pre-plated copper layer on the copper-clad ceramic substrate to form a stacked structure;

Step 1.7: Applying pressure from both the top and the bottom of the stacked structure in a helium protective atmosphere at a temperature of 280°C, wherein the pressure is 20 MPa, and the holding time is 10 minutes; and

Step 1.8: Air cooling the bonded silicon-based IGBT chip and the copper-clad ceramic substrate to room temperature to obtain the bonded assembly.

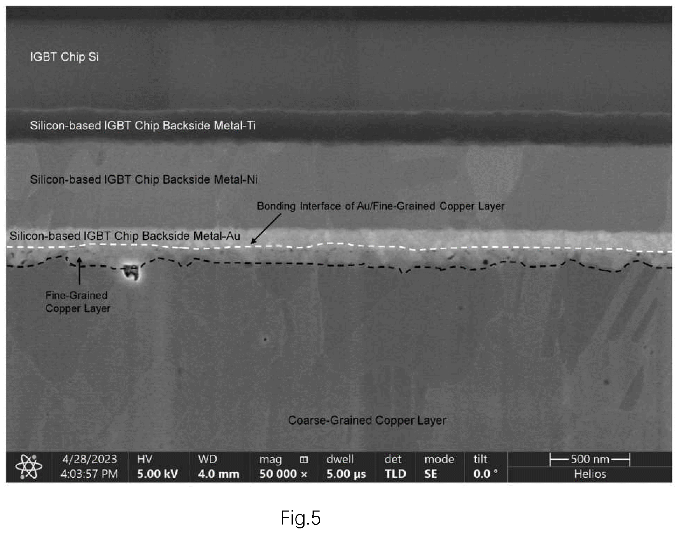

To better show the details of the assembly, the obtained bonded assembly is sectioned. Fig. 4 shows a SEM image of a cross-section of the bonded assembly obtained using the above method according to the first embodiment of the present invention. Fig. 5 is a locally enlarged view of Fig. 4. As shown in Figs. 4 and 5, the obtained bonded assembly comprises the silicon-based IGBT chip, the copper-clad ceramic substrate, and a connecting copper layer between them that secures them together. This connecting copper layer is a fine-grained copper layer, two sides thereof are respectively bonded to the outermost gold layer of the chip and the coarse-grained copper layer (i.e., the first copper layer) of the copper-clad substrate, correspondingly forming a first interface and a second interface. The circled areas in Fig. 4 are pore locations. None of the pores are larger than 200 nm (based on the maximum measurable dimension of each pore as shown in the figure), which is confirmed in Fig. 5. In Fig. 5, the white dashed line indicates the interface between the gold layer and the fine-grained copper layer determined by software identification, and the black dashed line indicates the interface between the coarse-grained copper layer and the fine-grained copper layer determined by software identification. As shown in Fig. 5, several voids are present on the fine-grained copper layer side near the interface between the gold layer and the fine-grained copper layer. These voids will be subsequently measured to calculate porosity.

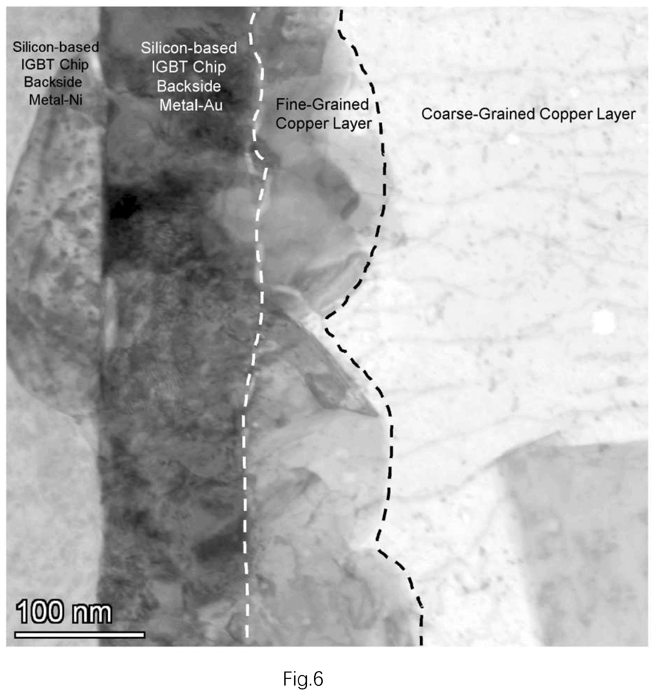

Fig. 6 shows a TEM image of the cross-section of the bonded assembly according to the first embodiment of the present invention, wherein the average grain diameter of the fine-grained copper layer is approximately 70 nm, and its thickness is approximately 100 nm. Compared to the pre-plated copper layer before forming the bonded assembly, the grain size of the connecting copper layer has increased, but the thickness remains substantially unchanged. This is because, during the bonding process, the grains in the pre-plated copper layer grow through mutual coalescence. This coalescence occurs through the gradual migration of grain boundaries, i.e., the grain boundaries of some grains advance into neighboring grains, thereby assimilating them. Consequently, the connecting copper layer of the obtained bonded assembly can inherit the thickness of the pre-plated copper layer while experiencing grain growth. Nanocrystals are highly active, and thus can very easily grow through this type of coalescence at bonding temperatures. However, once the grain size exceeds 100 nm, the activity of nanocrystals decreases exponentially, leading to significantly slower growth (see subsequent Embodiments 2 and 3).

According to formula (1), where $D_{gb}$ and $D_1$ take the values of $D_{Au/Cu\text{-}gb}$ and $D_{Au/Cu\text{-}l}$ at the current temperature, respectively. At 200°C, $D_{Au/Cu\text{-}gb}$ = $7.3 \times 10^{-19}$ $m^2s^{-1}$, $D_{Au/Cu\text{-}l}$ = $1.0 \times 10^{-24}$ $m^2s^{-1}$. A grain size of 70 nm results in an effective diffusion rate of gold atoms in the fine-grained copper layer at 200°C, $D_{Au/Cu\text{-}eff}$, of $1.6 \times 10^{-21}$ $m^2s^{-1}$. This is closer to the diffusion rate of copper atoms in the gold layer ($7.3 \times 10^{-21}$ $m^2s^{-1}$), compared to the effective diffusion rate in the coarse-grained copper, $D_{Au/Cu\text{-}eff}'$ = $3.2 \times 10^{-23}$ $m^2s^{-1}$ (grain size > 500 nm). At 300°C, $D_{Au/Cu\text{-}gb}$ = $4.8 \times 10^{-15}$ $m^2s^{-1}$, $D_{Au/Cu\text{-}l}$ = $9.0 \times 10^{-24}$ $m^2s^{-1}$. The calculated $D_{Au/Cu\text{-}eff}$ reaches $1.0 \times 10^{-16}$ $m^2s^{-1}$, which is closer to the diffusion rate of copper atoms in the gold layer ($6.0 \times 10^{-17}$ $m^2s^{-1}$), compared to $D_{Au/Cu\text{-}eff}'$ in the coarse-grained copper equaling to $9.4 \times 10^{-20}$ $m^2s^{-1}$. Therefore, the bonded assembly with the aforementioned connecting copper layer can avoid or at least mitigate the impact of the Kirkendall effect on its performance during subsequent use at 200 to 300°C. This is verified by the subsequent high-temperature durability test results.

To calculate porosity, sampling is performed at five locations on the cross-section of the obtained bonded assembly (one location is schematically shown in Fig. 4) within the following field of view: a width extending 1 $\mu$m outward from the first interface between the gold layer and the connecting copper layer and from the second interface between the connecting copper layer and the coarse-grained copper layer, respectively, in a direction away from the connecting copper layer (i.e., including the connecting copper layer); and a length of any 10 $\mu$m along a length direction of the first/second interface. In this example, the sampling region is approximately 22 $\mu$m$^2$. The total pore area at each location is measured, with specific results listed in Table 2. Based on Table 2, the average porosity in this embodiment is approximately 0.79 ± 0.09 %. In addition, the maximum measured dimension of pores at the sampling locations does not exceed 200 nm.

In addition, the resistivity of the connecting copper layer is tested. Specifically, by simulating the bonding scenario, a pre-plated copper layer with a thickness of 100 nm and a grain size of 30 nm is deposited on the surface of a silicon wafer having a 1 $\mu$m first copper layer. A 100 nm gold layer is directly sputtered onto the pre-plated copper layer, and the aforementioned heating and pressure is applied to simulate the bonded assembly obtained after bonding. Four-point probe thin-film resistivity measurements show that the connecting copper layer has an average resistivity of 3.0 ± 1.4 $\mu\Omega\cdot$cm. This low resistivity corresponds to the low porosity, which is conducive to enabling high-power operation of the bonded assembly.

Table 2: Porosity in the First Embodiment of the Present Invention (Sampling area is approximately 22 $\mu m^2$)

|  | Location 1 | Location 2 | Location 3 | Location 4 | Location 5 |
|---|---|---|---|---|---|
| Pore Area/$\mu m^2$ | 0.15 | 0.18 | 0.10 | 0.22 | 0.23 |
| Porosity | 0.68% | 0.81% | 0.45% | 1.0% | 1.0% |

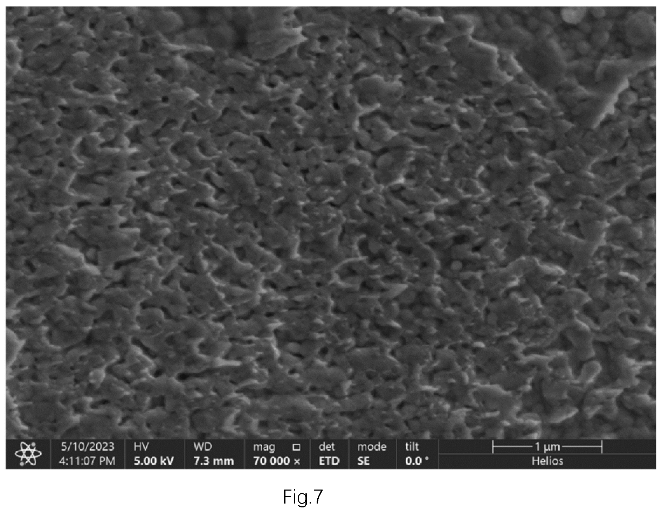

Shear fracture testing is performed on the bonded assembly of this embodiment. The shear strengths of five samples are 35.8 MPa, 36.6 MPa, 38.2 MPa, 34.7 MPa, and 36.2 MPa, respectively, with an average shear strength of 36.3 ± 1.2 MPa. Fig. 7 shows a SEM image of the shear fracture surface of the bonded assembly of this embodiment, which exhibits ductile fracture characteristics.

In addition, to verify the service stability of the bonded assembly of the present invention, a high-temperature durability test is conducted on the bonded assembly of this embodiment. The test parameters are as follows: the sample is held at 250°C in a vacuum environment for 165 hours; after the holding, the sample is air-cooled. Subsequently, porosity measurement, resistivity measurement and shear fracture testing are performed on the sample after the high-temperature durability test, as described above.

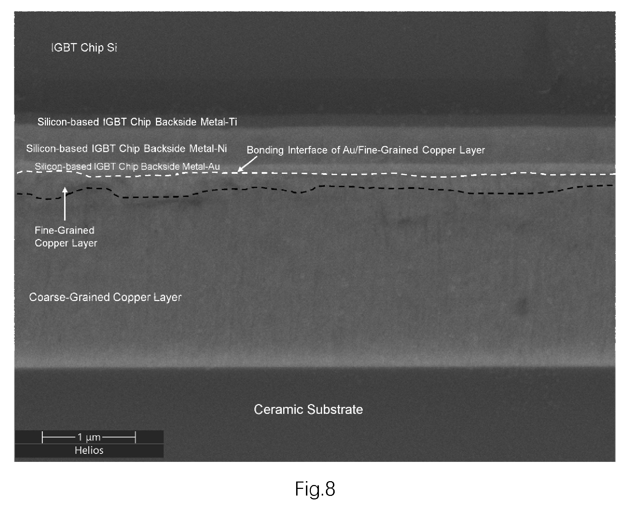

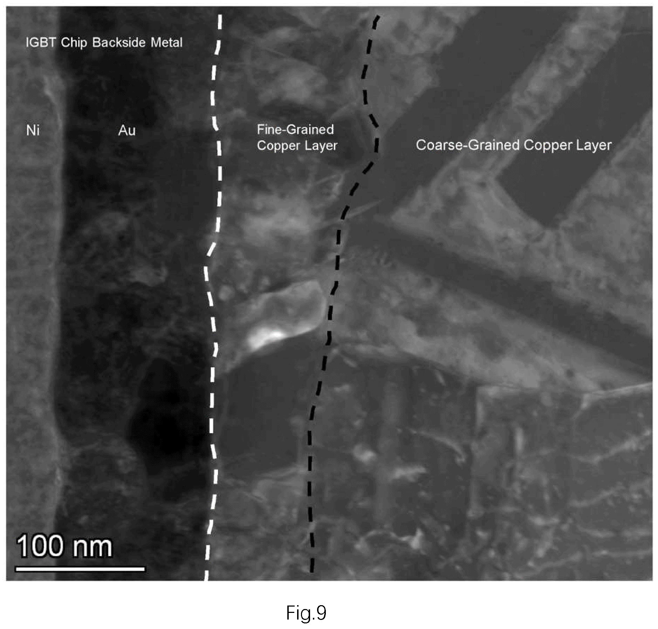

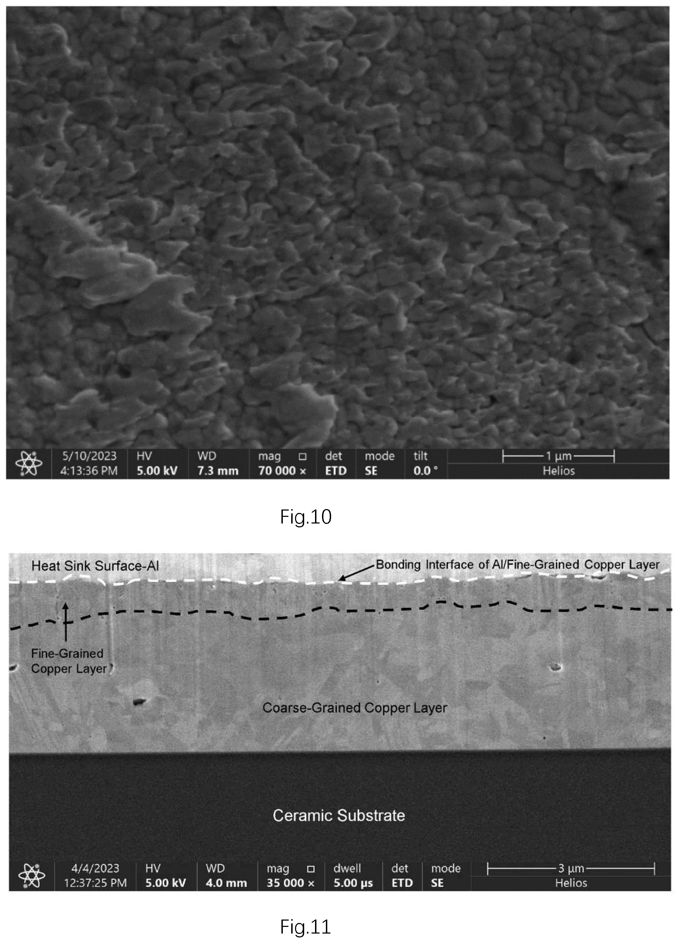

Figs. 8 and 9 both show images of the cross-section of the bonded assembly according to the first embodiment of the present invention after the high-temperature durability test, wherein no significant Kirkendall voids or formation of intermetallic compounds are observed. The average porosity of the bonded assembly after the high-temperature durability test remains almost unchanged, at 0.82 ± 0.15 %. The average resistivity increases slightly to 3.5 ± 1.2 $\mu\Omega\cdot$cm. For the shear fracture testing, the shear strengths of five samples after the high-temperature durability test are 32.7 MPa, 35.2 MPa, 33.8 MPa, 34.5 MPa, and 31.3 MPa, respectively, with an average shear strength of 33.5 ± 1.3 MPa. Compared to the shear strength before the high-temperature durability test, the average shear strength experiences a decrease of only about 7.7%, still demonstrating excellent shear resistance. In addition, as shown in Fig. 10, the shear fracture surface of the bonded assembly after the high-temperature durability test still exhibits ductile fracture characteristics, with no oxide concentration.

Based on the above, the boned assembly obtained according to the first embodiment of the present invention inherently has a porosity of no more than 1%, a resistivity of the connecting copper layer of approximately 3.0 ± 1.4 $\mu\Omega\cdot$cm, and a shear strength of 36.3 ± 1.2 MPa. Furthermore, even after the high-temperature durability test, the bonded assembly still maintains low porosity and resistivity as well as high shear strength, achieving long-term reliable service of the bonded assembly under high-power operation. This is attributed to the fact that in this bonded assembly, Kirkendall voids are either extremely rare or, when present, remain very small in size. This enables the embodiment to avoid or at least mitigate the impact of Kirkendall voids on the performance of the bonded assembly.

Second Embodiment

The method for producing a bonded assembly according to the second embodiment of the present invention is similar to that of the first embodiment, except for the following differences:

1) The components to be bonded are a copper-clad ceramic substrate and an aluminum heat sink. The surface layer of the aluminum heat sink is an aluminum layer;
2) During the electrochemical deposition, a current density is 0.01 to 0.04 A/cm$^2$, an electrolyte solution contains 200 to 250 g/L anhydrous copper sulfate, 10 to 50 mL/L sulfuric acid, and 0.005 to 0.01 g/L thiourea, deposition time is 250 seconds, and the solution temperature is 30°C. The deposited pre-plated copper layer has an average thickness of about 700 nm and an average grain size of about 200 nm (its measurement method is the same as in the first embodiment and will not be repeated). This average thickness can avoid the formation of a single layer of grains during the bonding process and throughout the service life of the obtained bonded assembly, so as to reduce the influence of certain grain orientations on the diffusion rate of atoms. Similarly, this pre-plated copper layer may be deposited on the aluminum layer of the heat sink.

3) The bonding step: In a helium protective atmosphere at 280°C, pressure is applied from both the top and bottom of the stacked structure. The pressure is 20 MPa, and the holding time is 15 minutes.

Fig. 11 shows a SEM image of a cross-section of the bonded assembly of the second embodiment obtained using the above method, wherein the bonded assembly comprises the aluminum heat sink, the copper-clad ceramic substrate, and a connecting copper layer between them that secures them together. The connecting copper layer is a fine-grained copper layer, two sides thereof are respectively bonded to the surface aluminum layer of the aluminum heat sink and the coarse-grained copper layer of the copper-clad substrate, correspondingly forming a first interface and a second interface, as indicated by a white dashed line and a black dashed line in Fig. 11.

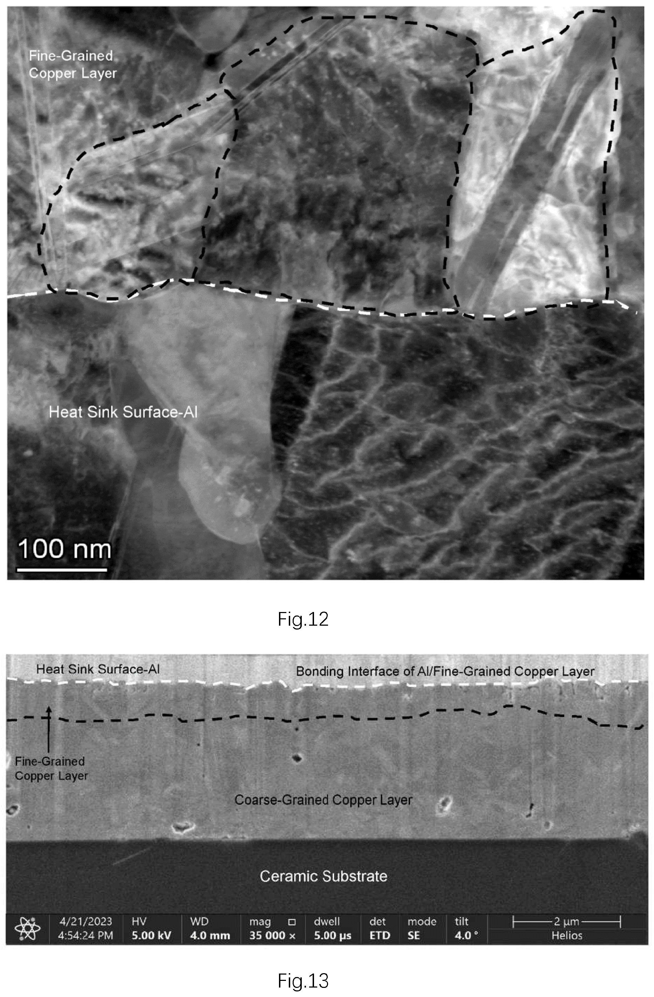

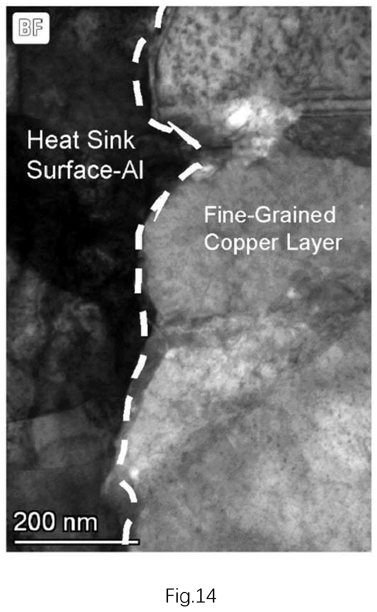

Similar to the first embodiment, corresponding measurements and tests are performed on the bonded assembly of the second embodiment. Fig. 12 shows a TEM image of the cross-section of the bonded assembly according to the second embodiment of the present invention, where the black dashed lines indicate several grains within the connecting copper layer. Due to heating during bonding, the average grain diameter of the connecting copper layer increases to about 220 nm, but its thickness remains approximately 700 nm. The bonded assembly of the second embodiment has an average porosity of 0.76 ± 0.05%, an average resistivity of the connecting copper layer of 3.8 ± 0.8 $\mu\Omega\cdot$cm, and a shear strength of 35.8 ± 1.1 MPa. Figs. 13 and 14 show SEM and TEM images of a cross-section of the bonded assembly according to the second embodiment of the present application after the high-temperature durability test, wherein no significant Kirkendall voids or formation of intermetallic compounds are observed. After the high-temperature durability test, the average porosity is 0.83 ± 0.10%, the average resistivity of the connecting copper layer is 4.3 ± 1.0 $\mu\Omega\cdot$cm, and the shear strength is 34.0 ± 2.2 MPa. The shear fracture surface of the bonded assembly of the second embodiment exhibits ductile fracture characteristics both before and after the high-temperature durability test.

Similarly, the bonded assembly of the second embodiment also has low porosity, low resistivity, and high shear strength, achieving long-term reliable service of the bonded assembly under high-power operation.

Third Embodiment

The method for producing a bonded assembly according to the third embodiment of the present invention is similar to that of the first embodiment, except for the following differences:

1) The components to be bonded are a copper conductive film and a silicon carbide MOSFET chip, wherein the copper conductive film is a coarse-grained copper film with a thickness of 20 $\mu$m, formed from coarse grains with an average size not less than 500 nm. The metal layers on the front surface of the SiC-based MOSFET chip are, from the inside out, a titanium layer, a nickel layer, and a silver layer.

2) The pre-plated copper layer is deposited on the copper conductive film. During the electrochemical deposition, a current density is 0.005 to 0.015 A/cm$^2$, deposition time is 350 seconds, and an electrolyte solution contains 200 to 250 g/L of anhydrous copper sulfate, 10 to 50 mL/L of sulfuric acid, and 0.005 to 0.01 g/L of thiourea. The deposited pre-plated copper layer has an average thickness of approximately 1 $\mu$m and an average grain size of about 360 nm. Similarly, the pre-plated copper layer may be deposited on the gold layer of a silicon-based IGBT chip.

3) The bonding step: In a helium protective atmosphere at 280°C, pressure is applied from both the top and the bottom of the stacked structure. The pressure is 15 MPa, and the holding time is 20 minutes.

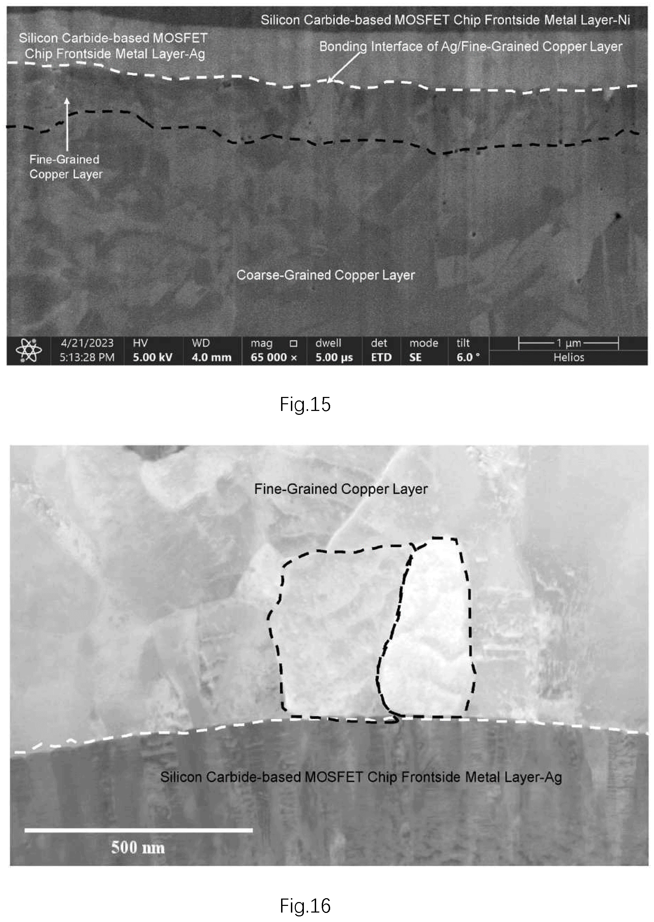

Fig. 15 shows a SEM image of a cross-section of the bonded assembly of the third embodiment obtained using the above method, wherein the bonded assembly comprises the silicon carbide MOSFET chip, the copper conductive film, and a connecting copper layer between them that secures them together. The connecting copper layer is a fine-grained copper layer, two sides thereof are respectively bonded to the surface silver layer of the silicon carbide MOSFET chip and the coarse-grained copper layer of the copper conductive film, correspondingly forming a first interface and a second interface, as indicated by a white dashed line and a black dashed line in Fig. 15.

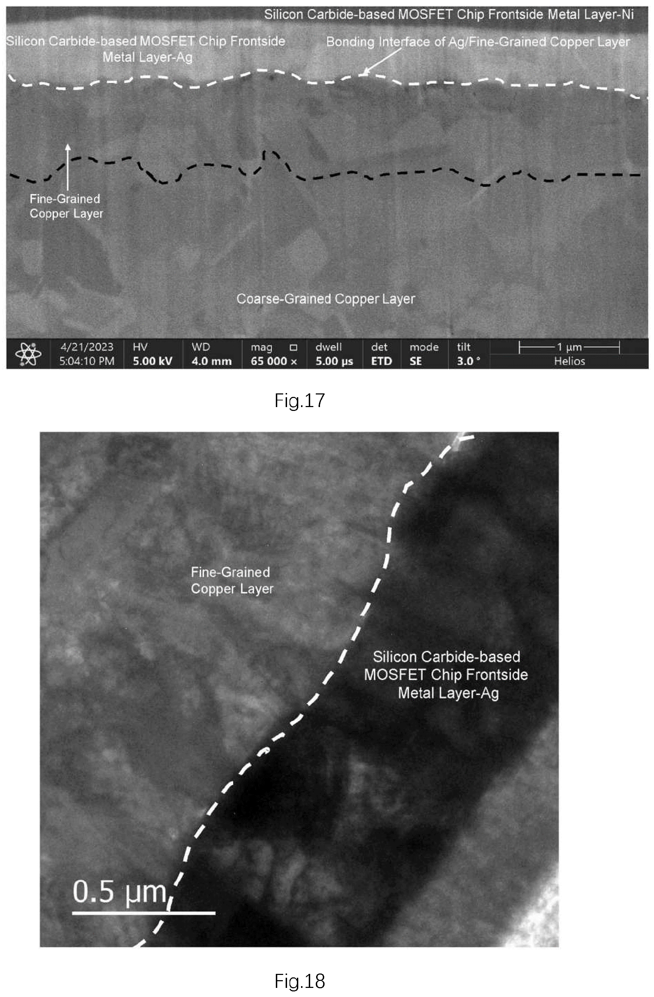

Similar to the first embodiment, corresponding measurements and tests are performed on the bonded assembly of the third embodiment. Fig. 16 shows a TEM image of a cross-section of the bonded assembly according to the third embodiment of the present invention, wherein the connecting copper layer has an average grain diameter of about 380 nm. The bonded assembly of the third embodiment has an average porosity of 0.82 ± 0.11%, an average resistivity of the connecting copper layer of 3.1 ± 1.0 $\mu\Omega\cdot$cm, and a shear strength of 33.4 ± 1.3 MPa. Figs. 17 and 18 show SEM images of a cross-section of the bonded assembly according to the third embodiment of the present application after the high-temperature durability test, wherein no significant Kirkendall voids or formation of intermetallic compounds are observed. After the high-temperature durability test, the bonded assembly has an average porosity of 1.39 ± 0.09%, an average resistivity of the connecting copper layer of 6.2 ± 1.1 $\mu\Omega\cdot$cm, and a shear strength of 32.8 ± 1.2 MPa. The shear fracture surface of the bonded assembly of the third embodiment exhibits ductile fracture characteristics both before and after the high-temperature durability test.

Similarly, the bonded assembly of the third embodiment also has low porosity, low resistivity, and high shear strength, achieving long-term reliable service of the bonded assembly under high-power operation.

These embodiments demonstrate that the bonded assembly of the present invention inherently has excellent properties (high electrical conductivity and thermal conductivity, and high shear strength). Furthermore, after prolonged use in high-temperature environments, it can still maintain excellent properties, ensuring the stability and reliability of devices including such bonded assemblies in long-term service. This is attributed to three factors: First, the bonded assembly of the present invention itself contains minimal defects such as Kirkendall voids, so these defects have little impact on subsequent service performance. Second, the fine grains in the connecting copper layer of the bonded assembly increase the diffusion rate of dissimilar metal atoms within it, thereby mitigating the Kirkendall effect caused by differences in diffusion rates. This suppresses or at least slows the formation and growth of Kirkendall voids, improving the stability of the bonded assembly during service. Third, the inherent stability of copper prevents the formation of brittle intermetallic compounds during the bonding process and the subsequent service, thereby avoiding the impact of intermetallic compounds on the performance of the obtained bonded assembly.

First Comparative Example

A silicon-based IGBT chip and a copper-clad ceramic substrate are soldered with tin-based solder paste SAC305, which is generally used in the industry. The specific steps are as follows: The silicon-based IGBT chip and the copper-clad ceramic substrate are cleaned separately to remove surface impurities, and dried. The backside metal layers of the silicon-based IGBT chip are, from the inside out, a titanium layer, a nickel layer, and a gold layer, while the copper-clad ceramic substrate has an initial copper layer. The tin-based solder paste is printed, using a tape, onto the surface of the initial copper layer of the copper-clad ceramic substrate over an area of 10 mm $\times$ 10 mm with a thickness of approximately 30 $\mu$m. Subsequently, the gold layer of the chip and the tin-based solder paste on the copper-clad ceramic substrate are brought into surface contact, to form a stacked structure of chip - tin-based solder paste - copper-clad ceramic substrate . This stacked structure is then held at 250°C in a vacuum environment for 2 minutes, followed by air cooling to room temperature.

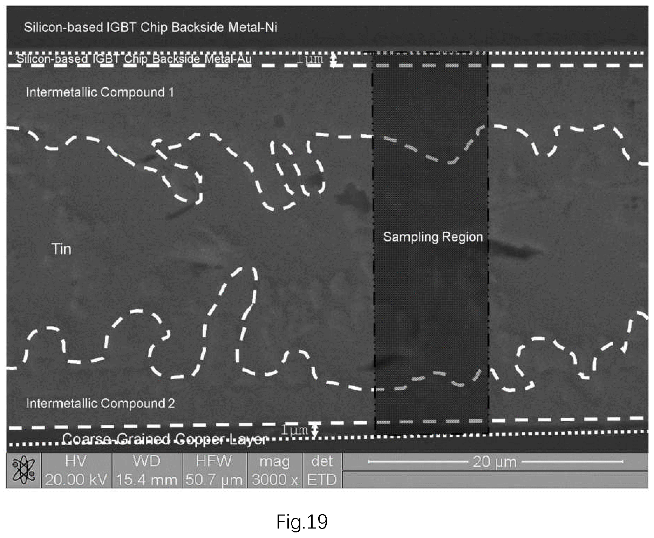

The soldered assembly obtained by the above method is shown in Fig. 19. It comprises the silicon-based IGBT chip, the copper-clad ceramic substrate, and a soldering portion between them. The soldering portion consists, from top to bottom, of: Intermetallic Compound Layer 1, tin solder layer, and Intermetallic Compound Layer 2. Intermetallic Compound Layer 1 and Intermetallic Compound Layer 2 in the soldering portion are respectively bonded to the outermost gold layer of the chip and the coarse-grained copper layer of the copper-clad substrate, correspondingly forming a first interface and a second interface, as indicated by white dashed lines in Fig. 19. These white dashed lines are interfaces between the layers determined by software identification. Edge recognition is used to calculate the area of the formed intermetallic compounds in the cross-section, and the average thickness of the intermetallic compounds is determined by the ratio of this area to the straight length of the interface. Sampling is performed at five locations on the cross-section of the same sample. The calculated average thickness of Intermetallic Compound Layer 1 in the soldering portion is 7.2 $\mu$m, and the average thickness of Intermetallic Compound Layer 2 is 5.3 $\mu$m. A sampling region for porosity has a length of 10 $\mu$m and a width which extends from 1 $\mu$m above the first interface between the gold layer on the chip surface and Intermetallic Compound Layer 1 to 1 $\mu$m below the second interface between Intermetallic Compound Layer 2 and the coarse-grained copper layer. This sampling region at least includes Intermetallic Compound Layer 1, tin solder layer, and Intermetallic Compound Layer 2, all of which are regions where Kirkendall voids are aggregated. The soldered assembly of this comparative example has an average porosity of 4.4 $\pm$ 1.5% and a resistivity of 140 $\pm$ 2 $\mu\Omega\cdot$cm.

Table 3: Porosity in the First Comparative Example of the Present Invention (Sampling Area is Approximately 300 $\mu$m$^2$)

|  | Location 1 | Location 2 | Location 3 | Location 4 | Location 5 |
|---|---|---|---|---|---|
| Pore Area | 7.5 | 14.1 | 16.5 | 8.0 | 19.5 |
| Porosity | 2.5% | 4.7% | 5.5% | 2.6% | 6.5% |

Similarly, shear fracture testing is conducted on the soldered assembly of this comparative example. The shear strengths of five samples are 22.1 MPa, 24.5 MPa, 23.8 MPa, 22.9 MPa, and 26.2 MPa, respectively, with an average shear strength of 23.9 $\pm$ 0.6 MPa, which is significantly lower than the shear strengths of the embodiments of the present application (approximately 33 to 36 MPa).

In addition, the soldered assembly of this comparative example is also subjected to a high-temperature durability test under the following parameters: the sample is held at 200°C in a vacuum environment for 72 hours, followed by air cooling.

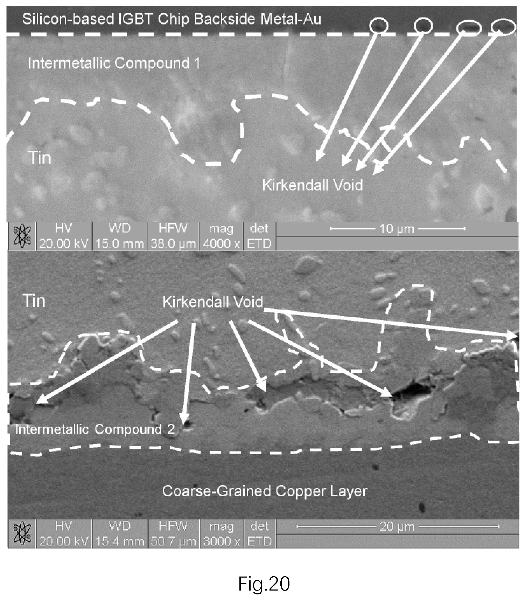

After the high-temperature durability test, cross-sections of the same sample are sampled at five different locations. As shown in Fig. 20, a large number of Kirkendall voids form at the interfaces (porosity is 10.8 ± 2.1%), which adversely affects the shear performance of the soldered assembly. Measurements show that the average thickness of Intermetallic Compound Layer 1 is 7.8 $\mu$m, while the average thickness of Intermetallic Compound Layer 2 is 9.5 $\mu$m, representing an increase of approximately 79.2% compared to that before the high-temperature durability test. This is because the energy required for the formation of Cu/Sn intermetallic compounds is lower than that for Au/Sn intermetallic compounds, leading to faster growth of Intermetallic Compound Layer 2 near the coarse-grained copper layer. The increase in thickness of the intermetallic compound indicates that the soldered assembly obtained using tin-based solder paste undergoes significant changes during high-temperature operation. Combined with the formation and growth of Kirkendall voids, this adversely affects the operational stability and durability of the soldered assembly.

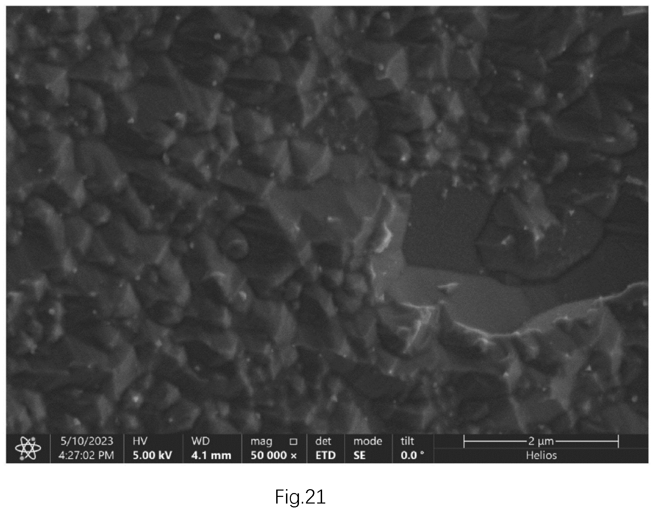

The shear fracture testing results confirm this adverse effect. The shear strengths of five samples after the high-temperature durability test are 18.0 MPa, 15.6 MPa, 23.8 MPa, 22.3 MPa, and 20.6 MPa, respectively, with an average shear strength of 20.3 ± 1.3 MPa. Compared to the shear strength before the high-temperature durability test, this represents a decrease of approximately 15%, which is significantly higher than the decrease in shear strength of the bonded assemblies of the embodiments of the present invention after the high-temperature durability test. Moreover, as shown in Fig. 21, the shear fracture surface of the soldered assembly in this comparative example exhibits a rock candy-like morphology after the high-temperature durability test, indicating a clear brittle fracture characteristic.

The soldered assembly of this comparative example not only contains intermetallic compound layers but also has a porosity exceeding 5%, which adversely reduce the shear strength of the obtained soldered assembly. Furthermore, as these intermetallic compounds and voids continue to form and grow during the service life of the soldered assembly, they adversely affect the electrical conductivity, thermal conductivity, operational stability, and durability of the soldered assembly.

Second Comparative Example

The method for producing the bonded assembly of the second comparative example is similar to that of the first embodiment, except for the following differences:

1) The copper-clad ceramic substrate has an initial copper layer with a thickness of approximately 1 $\mu$m and an average grain size not less than 500 nm.

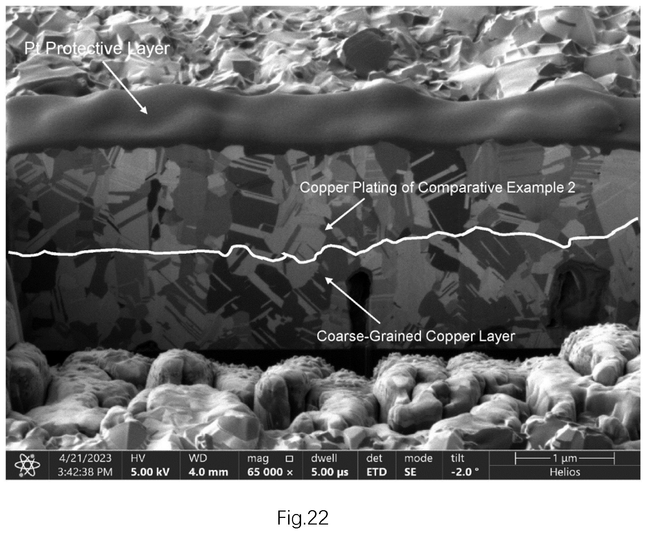

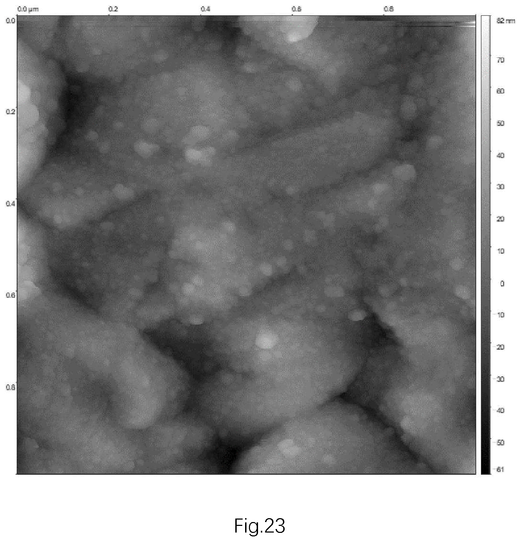

2) After electrochemically depositing the pre-plated copper layer, it is annealed to promote grain growth, wherein the electrochemical deposition parameters are as follows: direct current plating with a current density of 0.005 to 0.015 A/cm$^2$, an electrolyte solution contains 200 to 250 g/L of anhydrous copper sulfate and 10 to 50 ml/L of sulfuric acid, deposition time is 400 seconds, and solution temperature is 30°C. Fig. 22 shows a SIM image of a cross-section of the copper-clad ceramic substrate after annealing the pre-plated copper layer, where the average thickness of the pre-plated layer is about 1 $\mu$m. The annealed surface of the copper-clad ceramic substrate is shown in Fig. 23, where the average grain size of the pre-plated copper layer is approximately 500 nm.

3) Bonding step: In a helium protective atmosphere and at a temperature of 400°C, pressure is applied from both the top and the bottom of the stacked structure. The pressure is 20 MPa, and the holding time is 30 minutes.

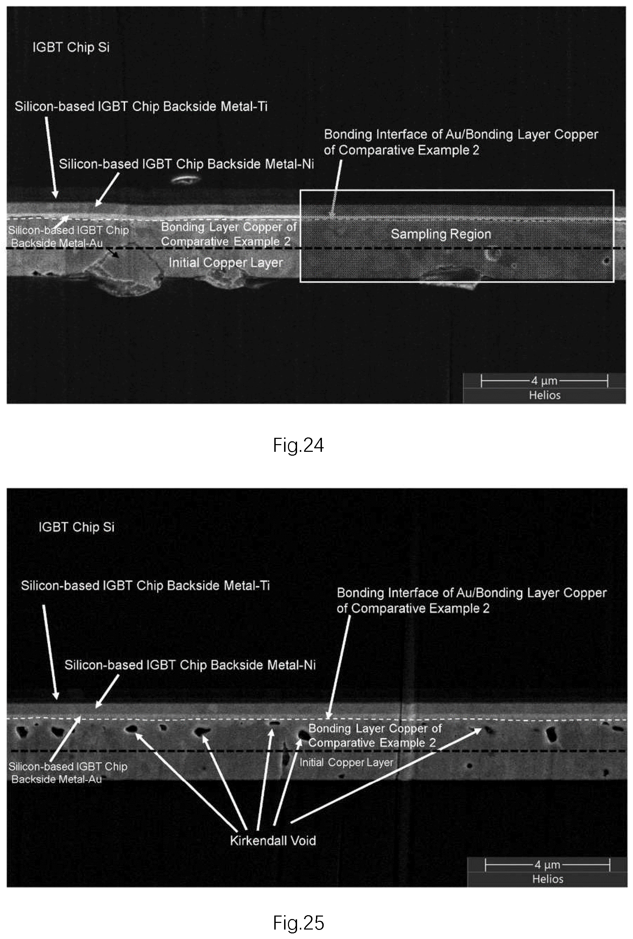

Fig. 24 shows a SEM image of a cross-section of the bonded assembly of the second comparative example obtained using the above method, wherein the obtained bonded assembly comprises: the silicon-based IGBT chip, the copper-clad ceramic substrate, and a coarse-grained copper layer between the two that secures the two together. The coarse-grained copper layer bonds to the outermost gold layer of the chip on one side and to the initial copper layer of the copper-clad ceramic substrate on the other side. Due to the similar grain sizes of the coarse-grained copper layer and the initial copper layer of the copper-clad ceramic substrate, grain boundary migration at high temperatures makes it impossible for software to directly distinguish between the coarse-grained copper layer and the initial copper layer of the copper-clad ceramic substrate. As mentioned earlier, the thickness of the pre-plated layer remains largely unchanged during bonding. Therefore, in Figs. 24 and 25, at 1 $\mu$m downward from the interface (indicated by a white dashed line) between the gold layer and the coarse-grained copper layer, a black dashed line marks a theoretical boundary of the coarse-grained copper layer formed by the pre-plated copper. No fine-grained connecting copper layer exists in this bonded assembly.

Similar to the first embodiment, corresponding measurements and tests are performed on the bonded assembly of the second comparative example. For porosity measurement, a sampling region is defined by: a length of any 10 $\mu$m along a length direction of the interface, and a width from 1 $\mu$m above the interface (i.e., the white dashed line) between the gold layer and the coarse-grained copper layer to 1 $\mu$m below the interface (i.e., the black dashed line) between the coarse-grained copper layer formed by the pre-plated copper and the initial copper layer of the copper-clad ceramic substrate, resulting in a measurement area of approximately 30 $\mu m^2$. The porosity of the bonded assembly of the second comparative example is 0.95 ± 0.20%, the average resistivity of the coarse-grained copper layer is 4.0 = 0.9 $\mu\Omega\cdot cm$, and the shear strength is 33.8 ± 1.0 MPa.

Fig. 25 shows a SEM image of a cross-section of the bonded assembly of the second comparative example after being held at 250°C for 165 hours, wherein a large number of Kirkendall voids are present within the coarse-grained copper layer near the interface between the gold layer and the copper layer. Measurements show that after the high-temperature durability test, the maximum size of individual pores reaches about 460 nm. Porosity and resistivity increase significantly to approximately 8.53 ± 0.12% and 58 ± 2 $\mu\Omega\cdot cm$, respectively, while shear strength drastically decreases to 22.3 ± 1.8 MPa. Furthermore, the shear fracture surface of the bonded assembly of the second comparative example changes from ductile to brittle fracture after the high-temperature durability test.

Relevant measurement data of each embodiment and comparative example are listed in Table 4.

Table 4: Porosity, Resistivity, and Shear Strength (Average Values) of Each Embodiment and Comparative Example

|  | First Embodiment | Second Embodiment | Third Embodiment | First Comparative Example | Second Comparative Example |
|---|---|---|---|---|---|
| Pre-plated Copper Layer | 30 nm | 200 nm | 360 nm | Not Applicable | 500 nm |
| Grain Size of Connecting Copper Layer | 70 nm | 220 nm | 380 nm | Does not exist | Does not exist |
| Porosity [1] | 0.79 ± 0.09 % | 0.76 ±0.05 % | 0.82 ± 0.11 % | 4.4 ± 1.5 % | 0.95 + 0.20 % |
| Shear Strength [1] /MPa | 36.3 ±1.2 | 35.8 ± 1.1 | 33.4 ± 1.3 | 23.9 ± 0.6 | 33.8 ± 1.0 |
| Resistivity [1]/$\mu\Omega\cdot cm$ | 3.0 ± 1.4 | 3.8 ± 0.8 | 3.1 ± 1.0 | 140 + 2 | 4.0 ± 0.9 |
| Porosity [2] | 0.82 ± 0.15 % | 0.83 ±0.10 % | 1.39 + 0.09 % | 10.8 + 2.1 % | 8.53 ± 0.12 % |
| Shear Strength 2/MPa | 33.5 +1.3 | 34.0 ± 2.2 | 32.8 ± 1.2 | 20.3 ± 1.3 | 22.3 ± 1.8 |
| Resistivity [2]/$\mu\Omega\cdot cm$ | 3.5 ± 1.2 | 4.3 ± 1.0 | 6.2 ± 1.1 | 183 ± 2 | 58 ± 2 |
| Fracture Characteristic [1/2] | Ductile/Ductile | Ductile/Ductil e | Ductile/Ductil e | Brittle/Brittl e | Ductile/Brittle |
| Note: [1] Data measured before the high-temperature durability test; [2] Data measured after the high-temperature durability test | | | | | |

Compared to the tin-based solder paste of the first comparative example, the bonded assemblies of the three embodiments adopting a pre-plated copper layer exhibit lower porosity and resistivity, and higher shear strength, both before use and after the high-temperature durability test, outperforming the soldered assembly obtained with the tin-based solder. This is because, on the one hand, the pre-plated copper layer itself is denser than the tin-based solder paste, effectively eliminating voids between particles in the solder paste. Besides, the small grain size of the connecting copper layer allows for roughly equal interdiffusion rates between the dissimilar metal (e.g., Al, Au, Ag, Ni) and copper, significantly reducing the formation and growth of Kirkendall voids, thereby mitigating their adverse effects on the long-term stability and reliability of the bonded assembly. On the other hand, the inherent stability of copper enables the bonded assembly to be free of brittle intermetallic compounds and also inhibits their formation in use, thus eliminating the detrimental effects associated with intermetallic compounds.

Although the bonded assembly in the second comparative example has performance comparable to the embodiments of the present invention before use, its durability test result is poor, failing to achieve good service stability and reliability. This demonstrates that merely employing a dense pre-plated copper layer does not guarantee a bonded assembly with good service performance.

Comparing the second comparative example with the embodiments of the present invention reveals that specific requirements exist for the grain size of the connecting copper layer of the formed bonded assembly to achieve good service performance. As shown by the second comparative example, when the grain size of the bonding portion of the bonded assembly exceeds 400 nm, both the service stability and electrical conductivity of the bonded assembly are insufficient. In contrast, as validated by the embodiments, when the average grain size of the connecting copper layer is between 35 nm and 400 nm, the small grains provide fast diffusion pathways for the dissimilar metal. This enables the diffusion rates of dissimilar metal atoms and copper atoms to satisfy $1/6D_{Cu/X} \leq D_{X/Cu\text{-eff}} \leq 6D_{Cu/X}$, thereby effectively mitigating the Kirkendall effect during service of the bonded assembly. That is, it significantly reduces the formation and growth of Kirkendall voids, and ensures the stability and electrical conductivity of the bonded assembly in its subsequent service life. Therefore, based on the requirement to use a pre-plated copper layer for bonding the first and second components, the present invention further requires that the average grain size of the connecting copper layer obtained from the pre-plated copper layer be between 35 nm and 400 nm to guarantee the stability and durability of the bonded assembly in high-temperature service environments.

In addition, the results from the embodiments also indicate that within this range, the smaller the grain size, the better the suppression of Kirkendall voids. For instance, compared to larger grain sizes, such as 380 nm in the third embodiment, when the grain size is between 70 nm and 220 nm, the porosity after high-temperature holding can still remain below 1%, resistivity below 5 $\mu\Omega\cdot$cm, and shear performance above 33 MPa, achieving further performance enhancement. In addition, Table 1 shows that for different metals, due to variations in diffusion coefficients, their preferred average grain sizes will differ. Therefore, a more preferred average grain size can be selected based on actual use conditions to further reduce the difference in diffusion rates between dissimilar metals to achieve better performance.

The present invention also encompasses a bonded assembly for semiconductor chip packaging that involves multiple components. For instance, the bonded assembly of the present invention comprises a bonded assembly formed from at least two of the first, second, and third embodiments. For example, as shown in Fig. 1, a bonded assembly according to yet another embodiment of the present invention comprises:

a semiconductor chip, having non-copper metal layers as the outermost layers on a first side and a second side of the semiconductor chip;
a copper-clad substrate, having a first copper layer and a second copper layer on a first side and a second side of the copper-clad substrate, respectively;
an aluminum heat sink, having an aluminum layer on a first side of the aluminum heat sink;
a copper conductive film, having a third copper layer on a first side of the copper conductive film;
a first connecting copper layer, whose two sides are respectively connected to the non-copper metal layer on the first side of the semiconductor chip and the third copper layer, thereby securing the semiconductor chip and the copper conductive film together;
a second connecting copper layer, whose two sides are respectively connected to the non-copper metal layer on the second side of the semiconductor chip and the first copper layer, thereby securing the semiconductor chip and the copper-clad substrate together; and
a third connecting copper layer, whose two sides are respectively connected to the second copper layer and the aluminum layer, thereby securing the copper-clad substrate and the aluminum heat sink together;
wherein average grain sizes of the first, second, and third connecting copper layers are 35 nm to 400 nm.

Preferably, the preferred grain sizes of the first, second, and third connecting copper layers may be selected based on the actual metals being connected, and the thicknesses of the first, second, and third connecting copper layers are at least one time the grain sizes.

The above embodiments and experimental data are provided to illustrate the present invention by way of example. Those skilled in the art should understand that the present invention is not limited to these embodiments, and various modifications may be made without departing from the scope of protection of the present invention. Furthermore, the steps in any of the above methods may not necessarily occur in the order depicted in the accompanying drawings, and in some cases, one or more of the depicted steps may occur substantially simultaneously or may involve additional steps.

**Claims**

1. A bonded assembly for power semiconductor module packaging, the bonded assembly comprising:

a first component, having a non-copper metal layer as the outermost layer on a first side of the first component;
a second component, having a first copper layer on a first side of the second component;
a connecting copper layer, whose two sides are respectively connected to the non-copper metal layer and the first copper layer to form a first interface and a second interface, thereby securing the first component and the second component together,
wherein an average grain size of the connecting copper layer is 35 nm to 400 nm.

2. The bonded assembly according to claim 1, wherein the average grain size of the connecting copper layer is 35 nm to 380 nm, and the average thickness of the connecting copper layer is 70 nm to 5 $\mu$m and at least one time the average grain size.

3.  The bonded assembly according to claim 1, wherein within a region defined by a width extending 1 $\mu$m outward from the first interface and from the second interface respectively in a direction away from the connecting copper layer and a length of any 10 $\mu$m along a length direction of the first interface, an average porosity of the bonded assembly is ≤ 3%, and a pore size of the bonded assembly is ≤ 200 nm.

4.  The bonded assembly according to claim 1, wherein within a region defined by a width extending 1 $\mu$m outward from the first interface and from the second interface respectively in a direction away from the connecting copper layer and a length of any 10 $\mu$m along a length direction of the first interface, an average porosity of the bonded assembly is ≤ 1%, and a pore size of the bonded assembly is ≤ 200 nm.

5.  The bonded assembly according to any one of claims 1 to 4, wherein the first component is a semiconductor chip, and the second component is a copper-clad substrate; or the first component is a semiconductor chip, and the second component is a copper conductive film or copper foil, wherein an average grain size of the first copper layer is ≥ 500 nm, wherein the semiconductor chip comprises a functional chip having silicon, silicon carbide, or gallium nitride as its main material, having one or more metal layers provided on its first side and second side, and having a non-copper metal layer as the outermost metal layer, wherein the non-copper metal layer is a gold layer, an aluminum layer, a silver layer, a nickel layer, or a titanium layer.

6.  The bonded assembly according to claim 5, wherein the non-copper metal layer is a gold layer, and the average grain size of the connecting copper layer is 35 nm to 140 nm.

7.  The bonded assembly according to claim 5, wherein the non-copper metal layer is a silver layer, and the average grain size of the connecting copper layer is 100 nm to 380 nm.

8.  The bonded assembly according to claim 1, wherein the average grain size of the connecting copper layer is 70 nm to 220 nm.

9.  The bonded assembly according to any one of claims 1 to 4, wherein the first component is a heat sink and its non-copper metal layer is an aluminum layer, and the second component is a copper-clad substrate, wherein an average grain size of the first copper layer is ≥ 500 nm.

10.  The bonded assembly according to any one of claims 1 to 4, wherein a shear strength of the bonded assembly is 30 to 40 MPa, and/or a resistivity of the connecting copper layer is ≤ 5 $\mu\Omega$·cm.

11.  The bonded assembly according to any one of claims 1 to 4, wherein the bonded assembly further comprises:

    a second copper layer provided on a second side of the second component;
    a third component, having a non-copper metal layer as the outermost layer on a first side of the third component;
    an additional connecting copper layer, whose two sides are respectively connected to the non-copper metal layer of the third component and the second copper layer, thereby securing the second component and the third component together;
    wherein an average grain size of the additional connecting copper layer is 35 nm to 400 nm.

12.  The bonded assembly according to any one of claims 1 to 4, after being held at 250°C for 165 hours, a shear strength of the bonded assembly is 30 to 35 MPa, a resistivity of the connecting copper layer is ≤ 7 $\mu\Omega$·cm, and/or an average porosity of the bonded assembly is ≤ 3%, and a pore size of the bonded assembly is ≤ 200 nm.

13.  A bonded assembly for power semiconductor module packaging, comprising:

    a semiconductor chip, having non-copper metal layers as the outermost layers on a first side and a second side of the semiconductor chip;
    a copper-clad substrate, having a first copper layer and a second copper layer on a first side and a second side of the copper-clad substrate, respectively;
    a heat sink, having an aluminum layer on a first side of the heat sink;
    a copper conductive film, having a third copper layer on a first side of the copper conductive film;

a first connecting copper layer, whose two sides are respectively connected to the non-copper metal layer on the first side of the semiconductor chip and the third copper layer, thereby securing the semiconductor chip and the copper conductive film together;

a second connecting copper layer, whose two sides are respectively connected to the non-copper metal layer on the second side of the semiconductor chip and the first copper layer, thereby securing the semiconductor chip and the copper-clad substrate together; and

a third connecting copper layer, whose two sides are respectively connected to the second copper layer and the aluminum layer, thereby securing the copper-clad substrate and the heat sink together;

wherein average grain sizes of the first, second, and third connecting copper layers are 35 nm to 400 nm.

14. The bonded assembly according to claim 13, wherein the average grain sizes of the first, second, and third connecting copper layers are 70 nm to 380 nm, and their average thicknesses are 70 nm to 5 $\mu$m and at least one time the average grain sizes.

15. The bonded assembly according to claim 13 or 14, wherein the non-copper metal layer of the semiconductor chip is a gold layer, an aluminum layer, a silver layer, a nickel layer, or a titanium layer, and/or an average porosity of the bonded assembly is $\leq$ 3%, more preferably $\leq$ 1%, and the pore size of the bonded assembly is $\leq$ 200 nm.

16. A method for producing a bonded assembly, comprising the steps of:

a) providing a first component and a second component to be bonded together, and performing cleaning and drying, wherein a first side of the second component has an initial copper layer, and the outermost layer on a first side of the first component is a non-copper metal layer;

b) introducing a pre-plated copper layer on the cleaned surface of the initial copper layer of the second component or on the cleaned outermost layer on the first side of the first component, and cleaning to remove an oxide layer on the surface of the pre-plated copper layer, wherein an average grain size of the pre-plated copper layer is 20 nm to 360 nm;

c) correspondingly bringing the pre-plated copper layer on the second component or the first component into surface contact with the non-copper metal layer of the first component or the initial copper layer of the second component, to form a stacked structure;

d) bonding the first component and the second component together using diffusion bonding.

17. The method according to claim 16, wherein an average grain size of the pre-plated copper layer is 25 nm to 360 nm.

18. The method according to claim 16 or 17, wherein the first component is a semiconductor chip, and its non-copper metal layer is a gold layer, an aluminum layer, a silver layer, a nickel layer, or a titanium layer; or the average grain size of the pre-plated copper layer is 30 nm to 200 nm.

19. The method according to claim 16 or 17, wherein in step d), the diffusion bonding is performed as follows: in a helium protective atmosphere at a temperature of 250 to 350°C, applying pressure from both the top and the bottom of the stacked structure, with a pressure of 15 to 40 MPa and a holding time of 10 to 30 minutes.

20. The method according to claim 16 or 17, wherein the pre-plated copper layer is formed by electroplating, vapor deposition, sputtering, or ion plating.

Fig.1

Fig.2

Fig.3

Fig.4

Fig.5

Fig.6

Fig.7

Fig.8

Fig.9

| | 5/10/2023 | HV | WD | mag □ | det | mode | tilt | 1 μm |
| | 4:13:36 PM | 5.00 kV | 7.3 mm | 70 000 × | ETD | SE | 0.0 ° | Helios |

Fig.10

Heat Sink Surface-Al

Bonding Interface of Al/Fine-Grained Copper Layer

Fine-Grained Copper Layer

Coarse-Grained Copper Layer

Ceramic Substrate

| | 4/4/2023 | HV | WD | mag □ | dwell | det | mode | 3 μm |
| | 12:37:25 PM | 5.00 kV | 4.0 mm | 35 000 × | 5.00 μs | ETD | SE | Helios |

Fig.11

Fig.12

Fig.13

Fig.14

Fig.15

Fig.16

Fig.17

Fig.18

Fig.19

Fig.20

Fig.21

Fig.22

Fig.23

Fig.24

Fig.25

# EP 4 765 204 A1

## INTERNATIONAL SEARCH REPORT

<table>
<tr><td colspan="2"></td><td>International application No.<br><br>**PCT/CN2024/106885**</td></tr>
</table>

| A. | CLASSIFICATION OF SUBJECT MATTER |
|---|---|

H01L23/492(2006.01)i; H01L21/60(2006.01)i

According to International Patent Classification (IPC) or to both national classification and IPC

| B. | FIELDS SEARCHED |
|---|---|

Minimum documentation searched (classification system followed by classification symbols)

IPC: H01L

Documentation searched other than minimum documentation to the extent that such documents are included in the fields searched

Electronic data base consulted during the international search (name of data base and, where practicable, search terms used)

CNABS, CNTXT, CNKI, VEN, USTXT, WOTXT, EPTXT: 功率, 铜, 晶粒, 颗粒, 粒子, 尺寸, 大小, 粒径, 纳米, 科肯达尔, 柯肯达尔, 覆铜, power, Cu, copper, grain?, particle?, size, nm, Kirkendall, copper clad, copper-clad, DBC

| C. | DOCUMENTS CONSIDERED TO BE RELEVANT |
|---|---|

| Category* | Citation of document, with indication, where appropriate, of the relevant passages | Relevant to claim No. |
|---|---|---|
| A | CN 105009278 A (MITSUBISHI MATERIALS CORP.) 28 October 2015 (2015-10-28) description, paragraphs [0052]-[0196], and figures 1-5 | 1-20 |
| A | CN 107004653 A (MITSUBISHI ELECTRIC CORP.) 01 August 2017 (2017-08-01) entire document | 1-20 |
| A | CN 112334239 A (Han Mun Soo) 05 February 2021 (2021-02-05) entire document | 1-20 |
| A | JP 2003078086 A (KUBOTA K.K. et al.) 14 March 2003 (2003-03-14) entire document | 1-20 |

☐ Further documents are listed in the continuation of Box C.    ☑ See patent family annex.

| * | Special categories of cited documents: | | |
|---|---|---|---|
| "A" | document defining the general state of the art which is not considered to be of particular relevance | "T" | later document published after the international filing date or priority date and not in conflict with the application but cited to understand the principle or theory underlying the invention |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **16 August 2024** | **08 September 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/106885**

| Patent document cited in search report | | | Publication date (day/month/year) | Patent family member(s) | | | Publication date (day/month/year) |
|---|---|---|---|---|---|---|---|
| CN | 105009278 | A | 28 October 2015 | JP | 2014209539 | A | 06 November 2014 |
| | | | | JP | 6621076 | B2 | 18 December 2019 |
| | | | | US | 2016021729 | A1 | 21 January 2016 |
| | | | | US | 9807865 | B2 | 31 October 2017 |
| | | | | WO | 2014157112 | A1 | 02 October 2014 |
| | | | | TW | 201503300 | A | 16 January 2015 |
| | | | | TWI | 621226 | B | 11 April 2018 |
| | | | | KR | 20150135285 | A | 02 December 2015 |
| | | | | KR | 102170623 | B1 | 27 October 2020 |
| | | | | EP | 2980844 | A1 | 03 February 2016 |
| | | | | EP | 2980844 | A4 | 02 November 2016 |
| | | | | EP | 2980844 | B1 | 05 August 2020 |
| CN | 107004653 | A | 01 August 2017 | WO | 2016121159 | A1 | 04 August 2016 |
| | | | | JP | 6272512 | B2 | 31 January 2018 |
| | | | | DE | 112015006049 | T5 | 12 October 2017 |
| | | | | US | 2017309544 | A1 | 26 October 2017 |
| | | | | US | 10510640 | B2 | 17 December 2019 |
| CN | 112334239 | A | 05 February 2021 | KR | 101961123 | B1 | 17 July 2019 |
| | | | | EP | 3799965 | A1 | 07 April 2021 |
| | | | | EP | 3799965 | A4 | 23 March 2022 |
| | | | | US | 2021296206 | A1 | 23 September 2021 |
| | | | | WO | 2020009338 | A1 | 09 January 2020 |
| JP | 2003078086 | A | 14 March 2003 | None | | | |

Form PCT/ISA/210 (patent family annex) (July 2022)